# EUROPEAN PATENT APPLICATION

(11) **EP 4 842 186 A1**
(43) Date of publication of application: **18.11.2026**
(21) Application number: 26172444.7
(22) Date of filing: 15.04.2026
(51) Int. Cl.: H10P 72/00, B08B 3/02, B08B 9/032

(54) **CLEANING METHOD OF SUBSTRATE PROCESSING APPARATUS**

(30) Priority: 30.04.2025 JP 2025075508
(71) Applicant: SCREEN Holdings Co., Ltd., Kyoto-shi, Kyoto 602-8585 (JP)
(72) Inventor: NISHIDE, Hajime, Kyoto, 602-8585 (JP); YANO, Makoto, Kyoto, 602-8585 (JP); HIGASHI, Katsuei, Kyoto, 602-8585 (JP); LI, Mingjhe, Kyoto, 602-8585 (JP)
(74) Representative: Kilian Kilian & Partner mbB

(57) **Abstract**

A substrate processing apparatus includes a processing liquid nozzle for ejecting a processing liquid toward a substrate, a processing liquid supply line for supplying the processing liquid to the processing liquid nozzle, and a chamber. The processing liquid supply line includes a storage tank. A cleaning method of the substrate processing apparatus includes connecting a supply source of a predetermined cleaning solution to the processing liquid supply line, and causing a high-temperature cleaning solution obtained by heating the cleaning solution up to a temperature higher than a room temperature to flow into the processing liquid supply line to supply the high-temperature cleaning solution to a target space which is an inside of the storage tank or the chamber, to thereby generate a vapor of the cleaning solution inside the target space and condense the cleaning solution on a top surface and/or a side surface of the target space.

## Description

### [CROSS REFERENCE TO RELATED APPLICATION]

The present application claims the benefit of priority to Japanese Patent Application No. 2025-75508 filed on April 30, 2025, the content of which is incorporated herein by reference in its entirety.

### TECHNICAL FIELD

The present invention relates to a cleaning method of a substrate processing apparatus.

### BACKGROUND ART

In a process of manufacturing a semiconductor substrate (hereinafter, referred to simply as a "substrate"), conventionally, various processings are performed on the substrate by using a substrate processing apparatus. In the substrate processing apparatus, a processing liquid is supplied from a processing liquid supply line to a processing liquid nozzle and the processing liquid is ejected from the processing liquid nozzle toward the substrate inside a chamber. When particles are deposited inside pipes, valves, and the like (hereinafter, referred to simply as "pipes and the like") of the processing liquid supply line, the processing liquid containing the particles is disadvantageously supplied to the substrate. Then, by causing a predetermined liquid to flow in the processing liquid supply line for a long time (in other words, by performing flushing), cleaning of the processing liquid supply line is performed. In an apparatus disclosed in Japanese Patent Application Laid Open Gazette No. 2021-2551, pipes are cleaned by using DIW (De-Ionized Water) or hydrogen peroxide solution, and in an apparatus disclosed in Japanese Patent Application Laid Open Gazette No. 2022-148186, pipes are cleaned by using ammonia, isopropyl alcohol, hydrogen peroxide solution, or ozone water.

When particles are deposited on a top surface or a side surface (e.g., a portion on the side surface above a normal position) of a storage tank which stores a processing liquid therein in the processing liquid supply line, there is a possibility that the particles may drop to be mixed into the processing liquid and the processing liquid containing the particles may be supplied to the substrate. Further, also when particles are deposited on a top surface or a side surface of a chamber in which the substrate is disposed, the particles sometimes drop onto the substrate, to thereby cause trouble. Therefore, considering the inside of the storage tank or the chamber as a target space, required is a method of easily cleaning a top surface and/or a side surface of the target space.

### SUMMARY OF THE INVENTION

It is an object of the present invention to easily clean a top surface and/or a side surface of a target space in a substrate processing apparatus.

A first aspect of the present invention is intended for a cleaning method of a substrate processing apparatus, and in the cleaning method according to the first aspect of the present invention, the substrate processing apparatus includes a holder for holding a substrate, a processing liquid nozzle for ejecting a processing liquid toward the substrate, a processing liquid supply line for supplying the processing liquid to the processing liquid nozzle, and a chamber inside which the holder and the processing liquid nozzle are disposed, and the processing liquid supply line includes a storage tank capable of storing a liquid therein, and the cleaning method according to the first aspect of the present invention includes operations of a) connecting a supply source of a predetermined cleaning solution to the processing liquid supply line and b) causing a high-temperature cleaning solution obtained by heating the cleaning solution up to a temperature higher than a room temperature to flow into the processing liquid supply line to supply the high-temperature cleaning solution to a target space which is an inside of the storage tank or the chamber, to thereby generate a vapor of the cleaning solution inside the target space and condense the cleaning solution on a top surface and/or a side surface of the target space.

According to the present invention, it is possible to easily clean the top surface and/or the side surface of the target space in the substrate processing apparatus with the cleaning solution.

A second aspect of the present invention is intended for the cleaning method of a substrate processing apparatus according to the first aspect, and in the cleaning method according to the second aspect of the present invention, the target space is the storage tank, and the high-temperature cleaning solution is filled into the storage tank up to a position lower than a breathing hole provided in the storage tank in the operation b).

A third aspect of the present invention is intended for the cleaning method of a substrate processing apparatus according to the second aspect, and in the cleaning method according to the third aspect of the present invention, the processing liquid supply line further includes a circulation line for forming a circulation flow path in which the liquid circulates, together with the storage tank, by taking out the liquid inside the storage tank from one end thereof and returning the liquid into the storage tank from the other end thereof, and a heater for heating the liquid flowing in the circulation flow path, and the cleaning solution circulating in the circulation flow path is heated by the heater in the operation b).

A fourth aspect of the present invention is intended for the cleaning method of a substrate processing apparatus according to the third aspect, and the cleaning method according to the fourth aspect of the present invention further includes an operation of cleaning the circulation flow path by circulating the cleaning solution having a temperature lower than that of the high-temperature cleaning solution inside the circulation flow path and discharging the cleaning solution outside the circulation flow path before the operation b).

A fifth aspect of the present invention is intended for the cleaning method of a substrate processing apparatus according to any one of the second to fourth aspects, and in the cleaning method according to the fifth aspect of the present invention, the storage tank has a drain port, and the cleaning method according to the fifth aspect of the present invention further includes an operation of cleaning the storage tank by filling the cleaning solution having a temperature lower than that of the high-temperature cleaning solution into the storage tank and discharging the cleaning solution outside from the drain port before the operation b).

A sixth aspect of the present invention is intended for the cleaning method of a substrate processing apparatus according to any one of the second to fourth aspects (or any one of the second to fifth aspects), and in the cleaning method according to the sixth aspect of the present invention, another cleaning solution is supplied into the storage tank before the operation b), and the other cleaning solution is an acid or alkaline liquid.

A seventh aspect of the present invention is intended for the cleaning method of a substrate processing apparatus according to the sixth aspect, and in the cleaning method according to the seventh aspect of the present invention, the cleaning solution is water and the other cleaning solution is an aqueous solution.

An eighth aspect of the present invention is intended for the cleaning method of a substrate processing apparatus according to any one of the first to fourth aspects (or any one of the first to seventh aspects), and in the cleaning method according to the eighth aspect of the present invention, a temperature of the high-temperature cleaning solution is not lower than 65 °C.

A ninth aspect of the present invention is intended for the cleaning method of a substrate processing apparatus according to any one of the first to fourth aspects (or any one of the first to eighth aspects), and the cleaning method according to the ninth aspect of the present invention is performed at the time of installation to an installation location after conveyance of the substrate processing apparatus from a manufacturing location to the installation location.

These and other objects, features, aspects and advantages of the present invention will become more apparent from the following detailed description of the present invention when taken in conjunction with the accompanying drawings.

### BRIEF DESCRIPTION OF DRAWINGS

FIG. 1 is a view showing a layout of a substrate processing apparatus;
FIG. 2 is a view showing a configuration of a plurality of processing units, and part of a configuration of a processing liquid supply line;
FIG. 3 is a view showing another part of the configuration of the processing liquid supply line;
FIG. 4 is a view showing a configuration of a mixing valve;
FIG. 5 is a view used for explaining a state of the processing liquid supply line during substrate processing;
FIG. 6 is a flowchart showing an operation flow of a cleaning process of the substrate processing apparatus;
FIGs. 7A to 7D are views each used for explaining an apparatus cleaning process;
FIGs. 8A and 8B are views each used for explaining an apparatus cleaning process; and
FIGs. 9A and 9B are views each used for explaining an apparatus cleaning process.

### DESCRIPTION OF EMBODIMENTS

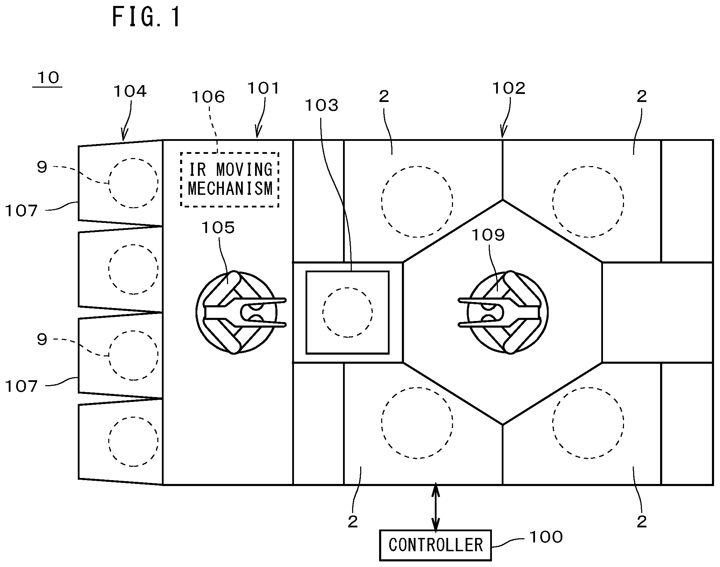

FIG. 1 is a view showing a layout of a substrate processing apparatus 10. The substrate processing apparatus 10 is a system for processing a disk-like semiconductor substrate 9 (hereinafter, referred to simply as a "substrate 9"). The substrate 9 is a product substrate (i.e., a substrate in the course of manufacturing a semiconductor product) from which a semiconductor product is to be eventually taken out. In the present specification, when a substrate is referred to simply as a "substrate 9", the substrate refers to a product substrate and does not include a substrate which is not to become a semiconductor product (a so-called dummy substrate).

The substrate processing apparatus 10 includes a controller 100, an indexer block 101, and a processing block 102 coupled with the indexer block 101. The controller 100 is implemented when a computer having a CPU, a memory, and the like executes a predetermined program, and performs general control of the substrate processing apparatus 10. Part of or the whole of the controller 100 may be implemented by a programmable logic controller (PLC) or the like.

The indexer block 101 includes a carrier holding part 104, an indexer robot 105, and an IR moving mechanism 106. The carrier holding part 104 holds a plurality of carriers 107 each of which can accommodate a plurality of substrates 9. The plurality of carriers 107 (e.g., FOUPs) are held by the carrier holding part 104 while being arranged in a predetermined carrier arrangement direction. The IR moving mechanism 106 moves the indexer robot 105 in the carrier arrangement direction. The indexer robot 105 performs an unloading operation for unloading the substrate 9 from the carrier 107 and a loading operation for loading the substrate 9 into the carrier 107. The substrate 9 is transferred in a horizontal posture by the indexer robot 105. A pass part 103 is provided between a center robot 109 described later in the processing block 102 and the indexer robot 105, and the indexer robot 105 transfers the substrate 9 between the pass part 103 and the carrier 107. In the pass part 103, the substrate 9 is temporarily held in the horizontal posture.

The processing block 102 includes a plurality of (e.g., four or more) processing units 2 for processing the substrate 9, and a center robot 109. The plurality of processing units 2 are so arranged as to surround the center robot 109 in a plan view. Two or more processing units 2 may be layered in an up-and-down direction. In the plurality of processing units 2, various processings are performed on the substrate 9. The center robot 109 passes the substrate 9 from/to the pass part 103. Further, the center robot 109 performs a loading operation for loading the substrate 9 into the processing unit 2 and an unloading operation for unloading the substrate 9 from the processing unit 2. The center robot 109 also transfers the substrate 9 among the plurality of processing units 2. The substrate 9 is transferred in the horizontal posture by the center robot 109.

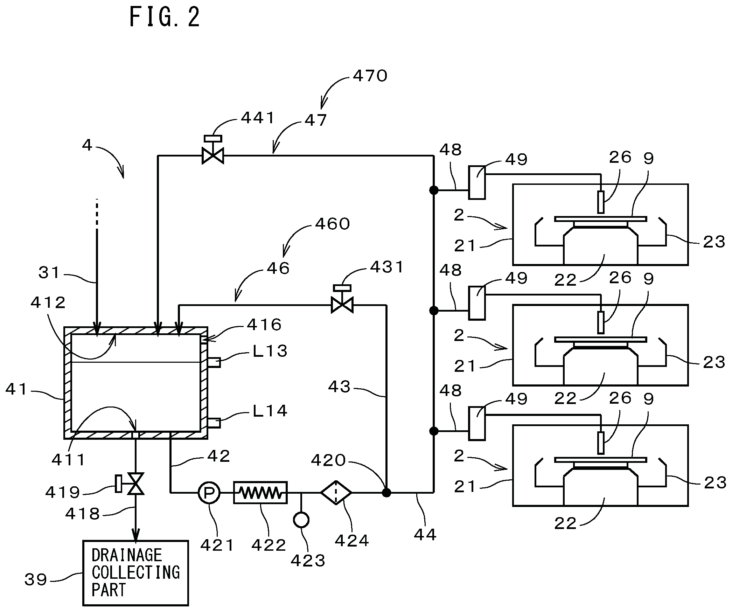

FIG. 2 is a view showing a configuration of the plurality of processing units 2, and part of a configuration of a later-described processing liquid supply line 4. FIG. 2 shows part of the configuration of the processing units 2 in a cross section of a plane including a predetermined central axis. In each of the processing units 2, performed is a single-substrate processing for processing the substrate 9 one by one.

The processing unit 2 includes a chamber 21, a spin chuck 22, a cup part 23, and a processing liquid nozzle 26. The chamber 21 is a container (also referred to as a housing) which forms a processing space for the substrate 9, and the spin chuck 22, the cup part 23, and the processing liquid nozzle 26 are disposed inside the chamber 21. The spin chuck 22 is a holder for holding the substrate 9, and in the exemplary case shown in FIG. 2, the spin chuck 22 holds the substrate 9 in the horizontal posture from below by a chuck part having a substantially disk-like shape around the central axis along the up-and-down direction. The chuck part is, for example, a vacuum chuck and comes into contact with a center portion of a lower main surface of the substrate 9 to adsorb the substrate 9. The chuck part may be a mechanical chuck or the like. A rotating mechanism is disposed below the chuck part. The rotating mechanism has a shaft and an electric motor and rotates the substrate 9 together with the chuck part around the central axis. The holder for holding the substrate 9 is preferably the spin chuck 22 and may be any other structure such as the chuck part or the like which is not rotated.

The cup part 23 is an annular member around the central axis and arranged around the spin chuck 22 along the entire circumference in a circumferential direction. The cup part 23 covers a side and a lower side of the substrate 9 held by the spin chuck 22 and receives the liquid spattering from the rotating substrate 9 toward the periphery. The cup part 23 is at rest in the circumferential direction regardless of whether the substrate 9 is rotated or still. On a bottom of the cup part 23, provided is a drainage port (not shown) for discharging the liquid received by the cup part 23 to outside the chamber 21. In the exemplary case shown in FIG. 2, the cup part 23 is movable in the up-and-down direction by a cup moving mechanism having an electric motor, a ball screw, and the like. The cup part 23 may have a plurality of cups layered in a radial direction.

The processing liquid nozzle 26 is supported by a not-shown nozzle moving mechanism. The nozzle moving mechanism has, for example, an electric motor, a ball screw, and the like and moves the processing liquid nozzle 26 in a substantially horizontal direction between a supply position above the substrate 9 held by the spin chuck 22 and an escape position outside the substrate 9 in the radial direction. The processing liquid nozzle 26 may be attached to a rotatable arm. As described later, the processing liquid nozzle 26 ejects a processing liquid toward the substrate 9. At the time of ejection of the processing liquid, the processing liquid nozzle 26 may be continuously or intermittently moved above the substrate 9 or may be stopped at a predetermined position above the substrate 9 (for example, above the center of the substrate 9).

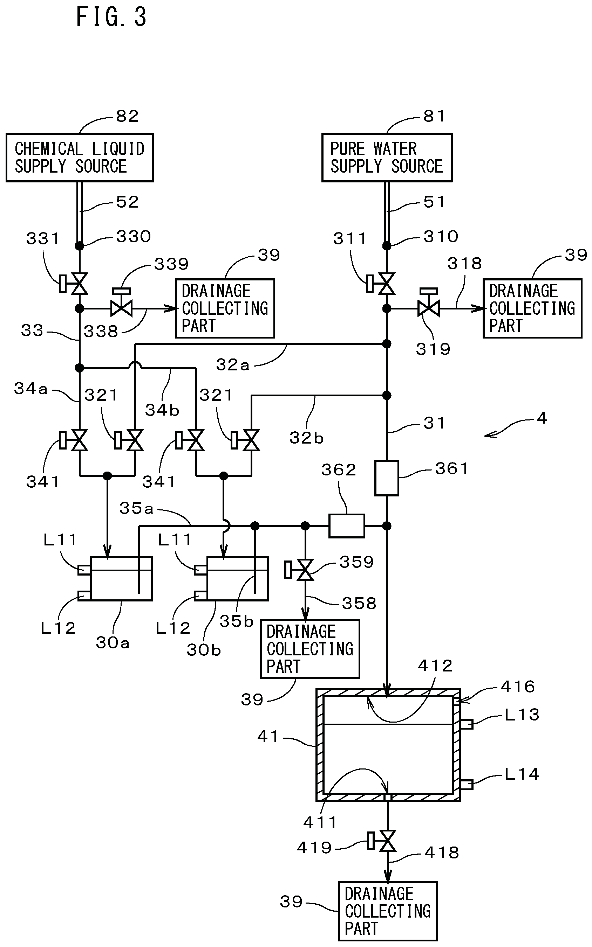

The substrate processing apparatus 10 further includes a processing liquid supply line 4. The processing liquid supply line 4 supplies the processing liquid to a plurality of processing liquid nozzles 26 in the plurality of processing units 2. FIG. 3 is a view showing another part of the configuration of the processing liquid supply line 4. FIG. 3 shows the configuration of the processing liquid supply line 4 on the upstream side relative to a later-described storage tank 41 (on the side of a pure water supply source 81 and a chemical liquid supply source 82), and FIG. 2 shows the configuration of the processing liquid supply line 4 on the downstream side relative to the storage tank 41 (on the side of the processing liquid nozzle 26). In the present specification, the processing liquid supply line 4 is a flow path of a liquid, most of which consists of pipes. The pipes are formed of, for example, a resin. The same applies to a pure water introduction line 31, pure water branch lines 32a and 32b, a chemical liquid introduction line 33, chemical liquid branch lines 34a and 34b, chemical liquid supply lines 35a and 35b, liquid exhaust lines 318, 338, 358, 418, and 498, a take-out line 42, a first return line 43, a second return line 44, and a branch line 48 described later, which are constituent components of the processing liquid supply line 4. Further, FIGs. 2 and 3 show only some of piping equipments (a valve, a flowmeter, and the like) provided in the processing liquid supply line 4, and actually more piping equipments are provided.

In the actual substrate processing apparatus 10, provided are a plurality of processing liquid supply lines for supplying a plurality of types of processing liquids to processing liquid nozzles (which may be nozzles different from the processing liquid nozzle 26), but FIGs 2 and 3 each show only one processing liquid supply line 4. Each of the other processing liquid supply lines may have a configuration in which some constituent components are omitted and/or changed from that of the processing liquid supply line 4, a configuration in which some other constituent component(s) is (are) added to that of the processing liquid supply line 4, or the like. Though attention is directed to only the processing liquid supply line 4 in a later-described apparatus cleaning process, the same process is performed on the other processing liquid supply lines.

As shown in FIG. 3, the processing liquid supply line 4 includes the storage tank 41, the two auxiliary tanks 30a and 30b, the pure water introduction line 31, the two pure water branch lines 32a and 32b, the chemical liquid introduction line 33, the two chemical liquid branch lines 34a and 34b, the two chemical liquid supply lines 35a and 35b, and the three liquid exhaust lines 318, 338, and 358. The storage tank 41 is a container capable of storing a liquid. Detailed structure of the storage tank 41 will be described later. Each of the auxiliary tanks 30a and 30b is also a container capable of storing a liquid and typically, the volume thereof is smaller than that of the storage tank 41. Each of the storage tank 41 and the auxiliary tanks 30a and 30b forms a space isolated from the outside air.

One end of the pure water introduction line 31 serves as an introduction port 310 (represented by a black point in FIG. 3) of pure water (DIW) in the processing liquid supply line 4, and the other end thereof is connected to the storage tank 41. The introduction port 310 of the pure water introduction line 31 is connected to a pure water supply source 81 with a primary-side connecting pipe 51. The pure water supply source 81 is a supply source of pure water contained in the processing liquid and is a facility in an installation location (factory or the like) of the substrate processing apparatus 10. In the vicinity of the introduction port 310 in the pure water introduction line 31, provided is a valve 311. One end of each of the pure water branch lines 32a and 32b is connected to a position between the valve 311 and the storage tank 41 in the pure water introduction line 31. The other end of the pure water branch line 32a is connected to the auxiliary tank 30a and the other end of the pure water branch line 32b is connected to the auxiliary tank 30b. A valve 321 is provided in each of the pure water branch lines 32a and 32b. During the later-described apparatus cleaning process, the pure water is supplied into the auxiliary tanks 30a and 30b from the pure water supply source 81.

One end of the chemical liquid introduction line 33 serves as an introduction port 330 (represented by a black point in FIG. 3) of a chemical liquid in the processing liquid supply line 4. The introduction port 330 of the chemical liquid introduction line 33 is connected to a chemical liquid supply source 82 with a primary-side connecting pipe 52. The chemical liquid supply source 82 is a supply source of the chemical liquid contained in the processing liquid and is a facility in the installation location (factory or the like) of the substrate processing apparatus 10. In the vicinity of the introduction port 330 in the chemical liquid introduction line 33, provided is a valve 331. The other end of the chemical liquid introduction line 33 branches out into two chemical liquid branch lines 34a and 34b, and the chemical liquid branch lines 34a and 34b are connected to the auxiliary tanks 30a and 30b, respectively. A valve 341 is provided in each of the chemical liquid branch lines 34a and 34b. In the exemplary case shown in FIG. 3, the chemical liquid branch line 34a and the pure water branch line 32a are joined on the side of the auxiliary tank 30a relative to the valves 321 and 341 and connected to the auxiliary tank 30a. Further, the chemical liquid branch line 34b and the pure water branch line 32b are joined on the side of the auxiliary tank 30b relative to the valves 321 and 341 and connected to the auxiliary tank 30b. During the substrate processing, the chemical liquid is supplied into the auxiliary tanks 30a and 30b from the chemical liquid supply source 82 and stored therein.

One end of the chemical liquid supply line 35a is connected to the auxiliary tank 30a, and the other end thereof is connected to the pure water introduction line 31. In the pure water introduction line 31, a connection position of the chemical liquid supply line 35a is provided on the side of the storage tank 41 relative to respective connection positions of the pure water branch lines 32a and 32b. One end of the chemical liquid supply line 35b is connected to the auxiliary tank 30b, and the other end thereof is connected to the chemical liquid supply line 35a. In other words, the chemical liquid supply lines 35a and 35b are joined on the opposite side to the auxiliary tanks 30a and 30b and connected to the pure water introduction line 31. During the substrate processing and the apparatus cleaning process, an inert gas such as nitrogen gas or the like is supplied into the auxiliary tanks 30a and 30b and the respective insides thereof are pressurized. The liquids inside the auxiliary tanks 30a and 30b are pumped to the pure water introduction line 31 through the chemical liquid supply lines 35a and 35b, respectively.

In the chemical liquid supply line 35a, between a connection position of the chemical liquid supply line 35b and the above-described other end (a connection position with the pure water introduction line 31), provided is a flow rate adjustment part 362. The flow rate adjustment part 362 includes, for example, an open/close valve, a flowmeter, and a flow rate regulating valve and adjusts the flow rate of the liquid flowing in the chemical liquid supply line 35a on the basis of the control of the controller 100. In the pure water introduction line 31, between the connection position of the chemical liquid supply line 35a and the respective connection positions of the pure water branch lines 32a and 32b, provided is a flow rate adjustment part 361. The flow rate adjustment part 361 includes, for example, an open/close valve, a flowmeter, and a flow rate regulating valve and adjusts the flow rate of the liquid flowing in the pure water introduction line 31 on the basis of the control of the controller 100.

In one example of the substrate processing, the chemical liquid flowing in the chemical liquid supply line 35a is mixed into the pure water flowing in the pure water introduction line 31, and the chemical liquid which is diluted with the pure water (hereinafter, referred to as a "diluted chemical liquid") is supplied into the storage tank 41. The diluted chemical liquid is stored inside the storage tank 41. The chemical liquid flowing in the chemical liquid supply line 35a does not necessarily need to be diluted with pure water. There may be a case, for example, where the chemical liquid flowing in the chemical liquid supply line 35a is supplied into the storage tank 41 through (part of) the pure water introduction line 31 in a state where the pure water is not flowing in the pure water introduction line 31 by closing the valve 311.

The liquid exhaust line 318 is provided in the vicinity of the introduction port 310 of the pure water introduction line 31. In the exemplary case shown in FIG. 3, one end of the liquid exhaust line 318 is connected to a position between the introduction port 310 and the respective connection positions of the pure water branch lines 32a and 32b in the pure water introduction line 31. The other end of the liquid exhaust line 318 is connected to the drainage collecting part 39. In the liquid exhaust line 318, provided is a valve 319. When the valve 319 is opened, the liquid flowing in the pure water introduction line 31 can be discharged to the drainage collecting part 39.

The liquid exhaust line 338 is provided in the vicinity of the introduction port 330 of the chemical liquid introduction line 33. In the exemplary case shown in FIG. 3, one end of the liquid exhaust line 338 is connected to a position between the introduction port 330 and a branch position of the chemical liquid branch lines 34a and 34b in the chemical liquid introduction line 33. The other end of the liquid exhaust line 338 is connected to the drainage collecting part 39. In the liquid exhaust line 338, provided is a valve 339. When the valve 339 is opened, the liquid flowing in the chemical liquid introduction line 33 can be discharged to the drainage collecting part 39.

The liquid exhaust line 358 is provided in the vicinity of the flow rate adjustment part 362 in the chemical liquid supply line 35a. In the exemplary case shown in FIG. 3, one end of the liquid exhaust line 358 is connected to a position between the connection position of the chemical liquid supply line 35b and the flow rate adjustment part 362 in the chemical liquid supply line 35a. The other end of the liquid exhaust line 358 is connected to the drainage collecting part 39. In the liquid exhaust line 358, provided is a valve 359. When the valve 359 is opened, the liquid flowing in the chemical liquid supply line 35a can be discharged to the drainage collecting part 39. Typically, the liquid exhaust lines 318, 338, and 358 are connected to the same drainage collecting part 39, but may be connected to different drainage collecting parts 39. The same applies to later-described liquid exhaust lines 418 and 498. During the apparatus cleaning process, the liquid exhaust lines 318, 338, and 358 are used.

As shown in FIG. 2, in a portion on a side surface of the storage tank 41 in the vicinity of a top surface 412 thereof (i.e., an upper portion on the side surface), provided is a breathing hole 416 communicating with outside air. The breathing hole 416 prevents the pressure inside the storage tank 41 from becoming excessively high. On a bottom of the storage tank 41, provided is a drain port 411, and one end of the liquid exhaust line 418 is connected to the drain port 411. The other end of the liquid exhaust line 418 is connected to the drainage collecting part 39. In the liquid exhaust line 418, provided is a valve 419. When the valve 419 is opened, the liquid inside the storage tank 41 can be discharged to the drainage collecting part 39.

The processing liquid supply line 4 further includes the take-out line 42, the first return line 43, the second return line 44, and a plurality of branch lines 48. One end of the take-out line 42 is connected to a lower portion of the storage tank 41. In the take-out line 42, provided is a later-described pump 421, and the liquid inside the storage tank 41 is taken out to the take-out line 42 by a liquid feed operation of the pump 421 to flow in the take-out line 42. The other end of the take-out line 42 is a node 420 to which one end of the first return line 43 and one end of the second return line 44 are connected. In other words, the take-out line 42 branches out into the first return line 43 and the second return line 44 at the node 420, and the liquid flows into the first return line 43 and the second return line 44. In the first return line 43 and the second return line 44, provided are valves 431 and 441, respectively.

The other end of the first return line 43 is connected to the storage tank 41, and the liquid flowing in the first return line 43 is returned into the storage tank 41. The take-out line 42 and the first return line 43 forms a first circulation line 46 for taking out the liquid inside the storage tank 41 from one end thereof and returning the liquid into storage tank 41 from the other end thereof. The other end of the second return line 44 is connected to the storage tank 41, and the liquid flowing in the second return line 44 is returned into the storage tank 41. The take-out line 42 and the second return line 44 forms a second circulation line 47 for taking out the liquid inside the storage tank 41 from one end thereof and returning the liquid into storage tank 41 from the other end thereof. In the processing liquid supply line 4, the storage tank 41 and the first circulation line 46 forms a first circulation flow path 460 in which the liquid circulates and the storage tank 41 and the second circulation line 47 forms a second circulation flow path 470 in which the liquid circulates. During the substrate processing, the diluted chemical liquid continuously flows in each of the first circulation flow path 460 and the second circulation flow path 470.

In the take-out line 42, the pump 421, a heater 422, a thermometer 423, and a filter 424 are provided in this order from the storage tank 41 toward the node 420. The pump 421 performs a liquid feed operation so as to cause the liquid inside the storage tank 41 to flow in each of the first circulation flow path 460 and the second circulation flow path 470. The heater 422 is, for example, an electric heater and heats the liquid flowing in the take-out line 42 as necessary. During the substrate processing, the heater 422 heats the diluted chemical liquid flowing in the take-out line 42. The thermometer 423 measures the temperature of the liquid flowing in the take-out line 42. Actually, the heater 422 is controlled on the basis of a measurement temperature of the thermometer 423. The filter 424 removes an unnecessary substance contained in the liquid.

The plurality of branch lines 48 are connected to the plurality of processing liquid nozzles 26 in the plurality of processing units 2, respectively. In each of the branch lines 48, an end portion on the opposite side to the processing liquid nozzle 26 is connected to the second return line 44. Thus, the plurality of branch lines 48 branch from the second circulation line 47 to be connected to the plurality of processing liquid nozzles 26, respectively. In each branch line 48, provided is a mixing valve 49.

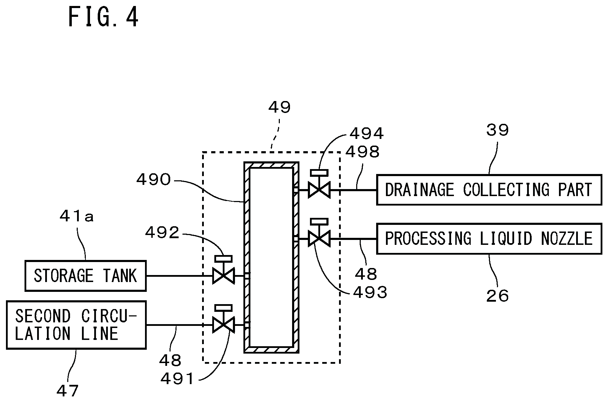

FIG. 4 is a view showing a configuration of the mixing valve 49. The mixing valve 49 is also termed a multiple valve and is capable of mixing together two or more types of liquids supplied therein. The mixing valve 49 includes a mixing body 490 and a plurality of valves 491 to 494. The mixing body 490 has an internal space for liquid mixing. Part of the branch line 48 on the side of the second circulation line 47 is connected to the mixing body 490 through a first valve 491 and the other part thereof on the side of the processing liquid nozzle 26 is connected to the mixing body 490 through a third valve 493. In other words, the first valve 491 is provided at an inflow port of the liquid to the mixing body 490 and the third valve 493 is provided at an outflow port to the processing liquid nozzle 26. In FIG. 4, the same reference number "48" is given to both a portion of the branch line 48 on the side of the second circulation line 47 and a portion of the branch line 48 on the side of the processing liquid nozzle 26. By opening the first valve 491, the liquid flowing in the second circulation flow path 470 is supplied into the mixing body 490. By opening the third valve 493, the liquid inside the mixing body 490 is supplied to the processing liquid nozzle 26.

In the processing liquid supply line 4, another storage tank 41a for storing another type of chemical liquid is also provided, and a line connected to the storage tank 41a is connected to the mixing body 490 through a second valve 492. During the substrate processing, by opening the second valve 492 as necessary, the chemical liquid inside another storage tank 41a can be supplied into the mixing body 490. Thus, in the mixing valve 49, the second valve 492 is provided at an inflow port of another liquid into the mixing body 490.

Further, one end of the liquid exhaust line 498 is connected to a fourth valve 494 of the mixing valve 49. The other end of the liquid exhaust line 498 is connected to the drainage collecting part 39. When the fourth valve 494 is opened, the liquid inside the mixing body 490 can be discharged to the drainage collecting part 39. In the mixing valve 49, the fourth valve 494 is provided at the drain port to the outside of the mixing body 490. In the mixing valve 49, three or five or more valves may be provided.

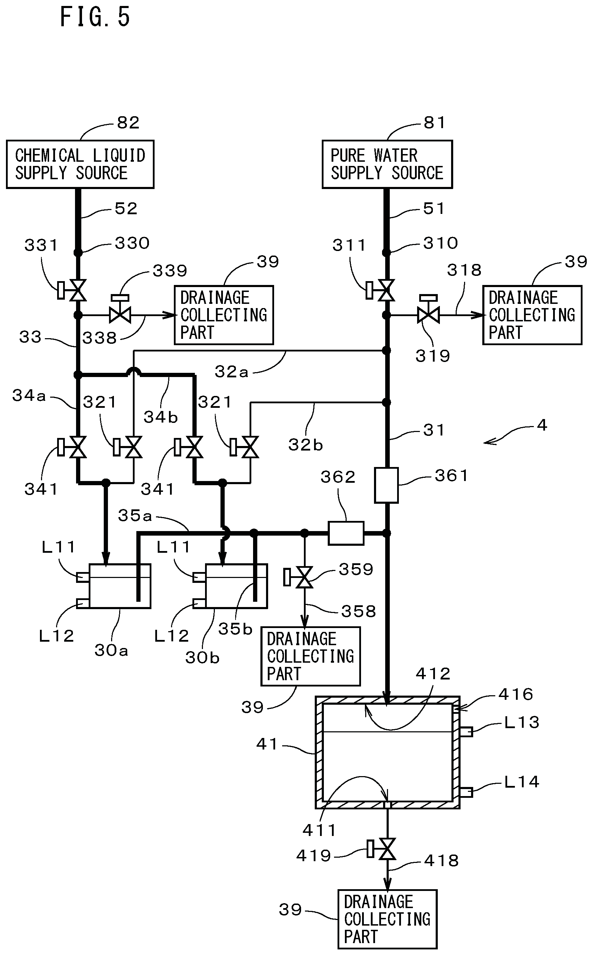

FIG. 5 is a view used for explaining a state of the processing liquid supply line 4 during the substrate processing and corresponds to FIG. 3. In FIG. 5, paths in which the chemical liquid, the pure water, and the diluted chemical liquid flow are indicated by thick solid lines. During the substrate processing in the substrate processing apparatus 10, the chemical liquid is supplied and stored into the auxiliary tanks 30a and 30b from the chemical liquid supply source 82 through the primary-side connecting pipe 52, the chemical liquid introduction line 33, and the chemical liquid branch lines 34a and 34b.

In each of the auxiliary tanks 30a and 30b in the present preferred embodiment, provided are a noncontact upper level sensor L11 and a noncontact lower level sensor L12. The upper level sensor L11 is attached to an upper portion (e.g., higher than the center in an up-and-down direction) of each of the auxiliary tanks 30a and 30b, and the lower level sensor L12 is attached to a lower portion of each of the auxiliary tanks 30a and 30b. When a liquid surface of the liquid inside each auxiliary tank 30a or 30b reaches a position of the upper level sensor L11 (i.e., when an output of the upper level sensor L11 indicates that the liquid is detected), the valve 341 is closed and the supply of the chemical liquid into the auxiliary tank 30a or 30b is stopped. When the liquid surface of the liquid inside each auxiliary tank 30a or 30b reaches below the lower level sensor L12 (i.e., when an output of the lower level sensor L12 indicates that the liquid is not detected), the valve 341 is opened and the chemical liquid is supplied into the auxiliary tank 30a or 30b. As the level sensors L11 and L12, various types of sensors, such as an electrostatic capacitive type sensor, an ultrasonic sensor, a laser type sensor, and the like, can be used. The same applies to later-described level sensors L13 and L14. The level (height) of the liquid surface inside each auxiliary tank 30a or 30b may be acquired by a camera or the like, or may be estimated on the basis of an accumulated value of the flow rate obtained by the flowmeter provided in the flow path (an inflow path and an outflow path) which is connected to the auxiliary tank 30a or 30b or an inflow time or an outflow time of the liquid. The same applies to the storage tank 41.

The chemical liquid inside the auxiliary tanks 30a and 30b is supplied to the pure water introduction line 31 through the chemical liquid supply lines 35a and 35b, respectively. In the pure water introduction line 31, the pure water is introduced from the pure water supply source 81 through the primary-side connecting pipe 51 and the chemical liquid from the auxiliary tanks 30a and 30b is mixed into the pure water flowing in the pure water introduction line 31. The diluted chemical liquid is thereby generated and supplied into the storage tank 41. At that time, since the flow rate of the pure water is adjusted by the flow rate adjustment part 361 and that of the chemical liquid is adjusted by the flow rate adjustment part 362, the diluted chemical liquid which is diluted at a desired concentration is stored in the storage tank 41. The pure water introduction line 31 serves as a flow path of the pure water for dilution.

Also in the storage tank 41, like in the auxiliary tanks 30a and 30b, provided are a noncontact upper level sensor L13 and a noncontact lower level sensor L14. The upper level sensor L13 is attached to an upper portion (e.g., higher than the center in an up-and-down direction) of the storage tank 41, and the lower level sensor L14 is attached to a lower portion of the storage tank 41. The upper level sensor L13 is positioned below the breathing hole 416. When a liquid surface of the diluted chemical liquid inside the storage tank 41 reaches a position of the upper level sensor L13, the respective open/close valves of the flow rate adjustment parts 361 and 362 are closed and the supply of the diluted chemical liquid into the storage tank 41 is stopped. Leaking of the diluted chemical liquid inside the storage tank 41 to the outside from the breathing hole 416 is thereby prevented. When the liquid surface of the diluted chemical liquid inside the storage tank 41 reaches below the lower level sensor L14, the respective open/close valves of the flow rate adjustment parts 361 and 362 are opened and the diluted chemical liquid is supplied into the storage tank 41. Further, a mist trap or the like is provided in an exhaust pipe communicating with the outside from the breathing hole 416, and a vapor or the like of the diluted chemical liquid inside the storage tank 41 is captured by the mist trap.

The diluted chemical liquid inside the storage tank 41 is taken out into the take-out line 42 shown in FIG. 2 and continuously flows in each of the first circulation flow path 460 and the second circulation flow path 470. At that time, the heater 422 is controlled on the basis of the measurement temperature of the thermometer 423, and the diluted chemical liquid having an almost constant temperature flows in the first circulation flow path 460 and the second circulation flow path 470. In the mixing valve 49 of each branch line 48, by opening the first valve 491 and the third valve 493 shown in FIG. 4, the diluted chemical liquid flowing in the second circulation flow path 470 is supplied to the processing liquid nozzle 26. Inside the chamber 21 shown in FIG. 2, the processing liquid nozzle 26 is disposed at the supply position above the substrate 9. The diluted chemical liquid is thereby ejected from the processing liquid nozzle 26 toward the substrate 9 as the processing liquid. The pure water from the pure water supply source 81 and the chemical liquid from the chemical liquid supply source 82 are component liquids contained in the processing liquid. In the mixing valve 49, any other type of chemical liquid may be further mixed into the diluted chemical liquid. Further, the chemical liquid which is not diluted with pure water may be used as the processing liquid.

The processing liquid ejected from the processing liquid nozzle 26 is, for example, hydrofluoric acid, sulfuric acid, acetic acid, nitric acid, hydrochloric acid, aqueous ammonia, hydrogen peroxide solution, organic acid, organic alkali, a surfactant, a corrosion inhibitor, or the like or a mixed solution containing any of those substances. An example of the mixed solution is SPM (sulfuric acid/hydrogen peroxide mixture), SC1 (ammonia hydrogen peroxide mixture), or the like. The processing liquid may contain pure water as a solvent.

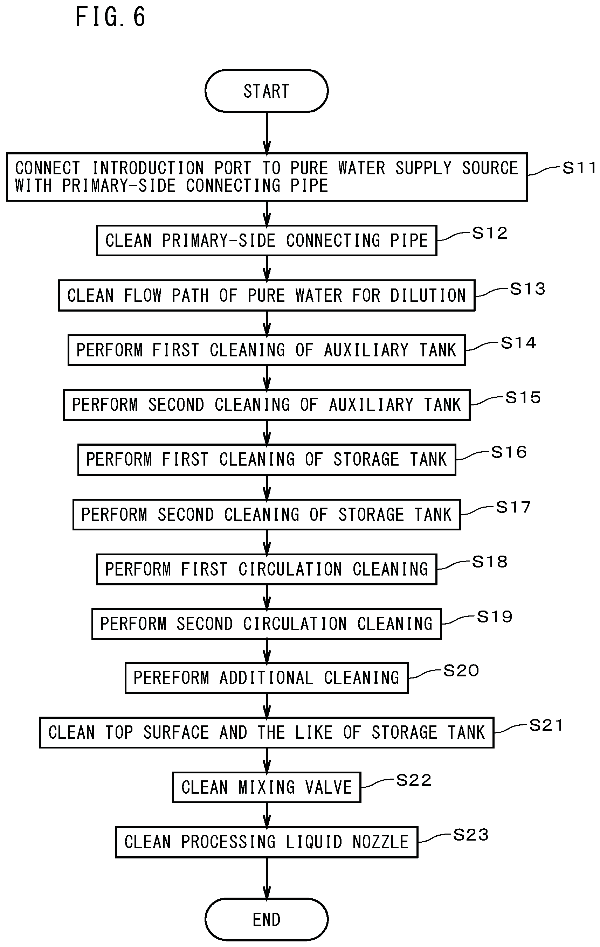

Next, with reference to FIG. 6, a cleaning process (hereinafter, referred to as an "apparatus cleaning process") of the substrate processing apparatus 10 will be described. FIG. 6 shows only the apparatus cleaning process using the pure water from the pure water supply source 81. As described later, the apparatus cleaning process using the chemical liquid from the chemical liquid supply source 82 is also performed in the same manner. In FIG. 6, process steps other than Step S11 described later may be performed by an operation of an operator or by a control of the controller 100. Herein, it is assumed that after conveyance of the substrate processing apparatus 10 from a manufacturing location to an installation location thereof, the apparatus cleaning process shown in FIG. 6 is performed at the time of installation (so-called start-up) to the installation location. As described later, the apparatus cleaning process shown in FIG. 6 may be performed at any timing other than the time of start-up.

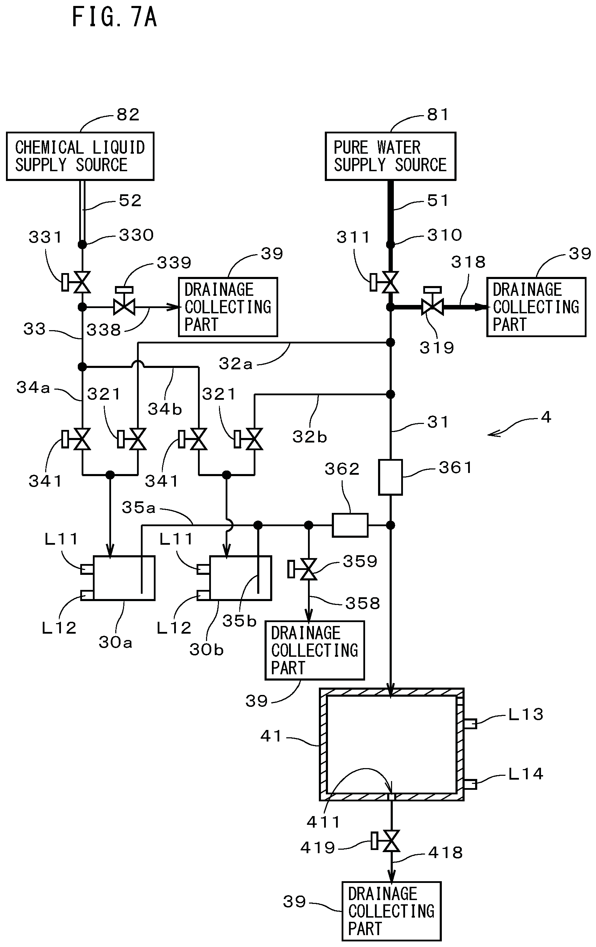

FIGs. 7A to 7D are views each used for explaining the apparatus cleaning process and corresponds to FIG. 3. In the apparatus cleaning process, first, the operator connects the introduction port 310 of the processing liquid supply line 4 to the pure water supply source 81 with the primary-side connecting pipe 51 (Step S11). The primary-side connecting pipe 51 is, for example, a pipe formed of a resin. Typically, in the manufacturing location of the substrate processing apparatus 10, the primary-side connecting pipe 51 is not attached to the introduction port 310, and at the time of installation to the installation location of the substrate processing apparatus 10, the primary-side connecting pipe 51 causes to be attached to the introduction port 310.

Subsequently, in a state where the valve 311 in the vicinity of the introduction port 310 and the valve 319 of the liquid exhaust line 318 are opened, pure water is supplied to the primary-side connecting pipe 51 from the pure water supply source 81. As indicated by a thick solid line in FIG. 7A, the pure water thereby flows into the liquid exhaust line 318 from the pure water supply source 81 through the primary-side connecting pipe 51 and the introduction port 310 and is discharged to the drainage collecting part 39. The flow of the pure water in the primary-side connecting pipe 51, the introduction port 310, and the liquid exhaust line 318 is continuously performed for a long time. The primary-side connecting pipe 51 is thereby cleaned (Step S12). The flow of a liquid for a long time is also referred to as flushing. At that time, the respective valves 321 of the pure water branch lines 32a and 32b and the open/close valve of the flow rate adjustment part 361 are closed, and the pure water does not flow into the auxiliary tank 30a or 30b or the storage tank 41. In the pure water introduction line 31, a valve may be provided between a connection position of the liquid exhaust line 318 and that of the pure water branch line 32a and this valve may be closed.

In a path of the pure water in the processing liquid supply line 4, when the connection position of the liquid exhaust line 318 is provided between the introduction port 310 and the tanks of the auxiliary tanks 30a and 30b and the storage tank 41, it can be considered that the liquid exhaust line 318 is provided in the vicinity of the introduction port 310. Further, the primary-side connecting pipe 51 may be cleaned by connecting the liquid exhaust line to a portion of the primary-side connecting pipe 51 in the vicinity of the connection position (i.e., the introduction port 310) with the processing liquid supply line 4 and discharging the pure water from the liquid exhaust line. When the connection position of the liquid exhaust line in the primary-side connecting pipe 51 is nearer to the introduction port 310 than the pure water supply source 81, it can be considered that the liquid exhaust line is provided in the vicinity of the introduction port 310. The preferable liquid exhaust line 318 is one that is arranged at a position nearest to the introduction port 310 among the lines into which the path from the pure water supply source 81 toward the storage tank 41 branches out. The same applies to the liquid exhaust line 338 in the chemical liquid introduction line 33.

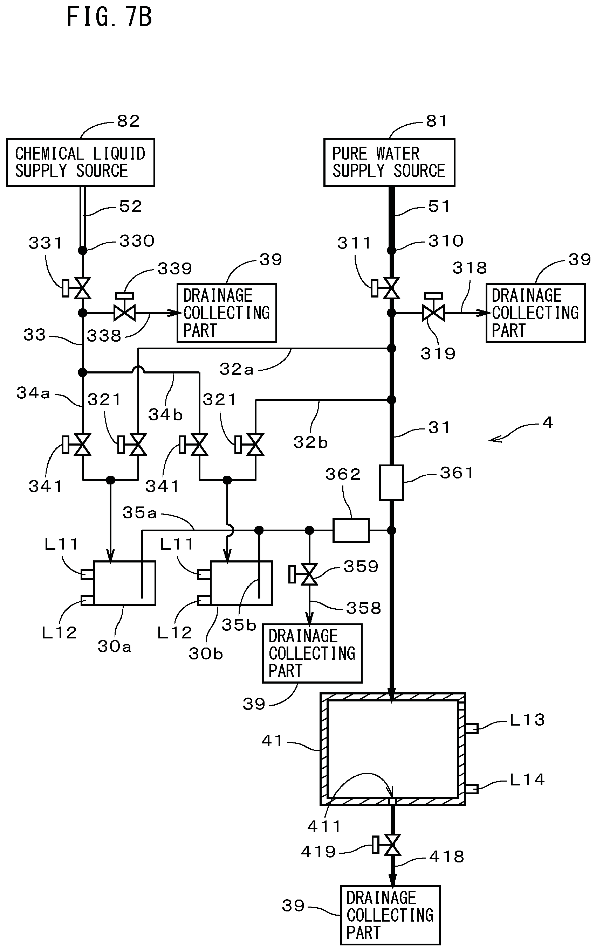

After the flow of the pure water from the pure water supply source 81 to the liquid exhaust line 318 has continued for a predetermined time, the valve 319 of the liquid exhaust line 318 is closed and the open/close valve of the flow rate adjustment part 361 is opened. As indicated by a thick solid line in FIG. 7B, the pure water thereby flows into the storage tank 41 from the pure water supply source 81 through the primary-side connecting pipe 51 and the pure water introduction line 31. Further, the valve 419 of the liquid exhaust line 418 connected to the storage tank 41 is opened and the pure water flowing into the storage tank 41 is immediately discharged to the drainage collecting part 39 through the liquid exhaust line 418. Thus, the pure water introduction line 31, i.e., the flow path of the pure water for dilution is cleaned (Step S13). At that time, since the primary-side connecting pipe 51 is already cleaned, contamination of the processing liquid supply line 4 (herein, the pure water introduction line 31) with the particles deposited on the primary-side connecting pipe 51 is more reliably suppressed.

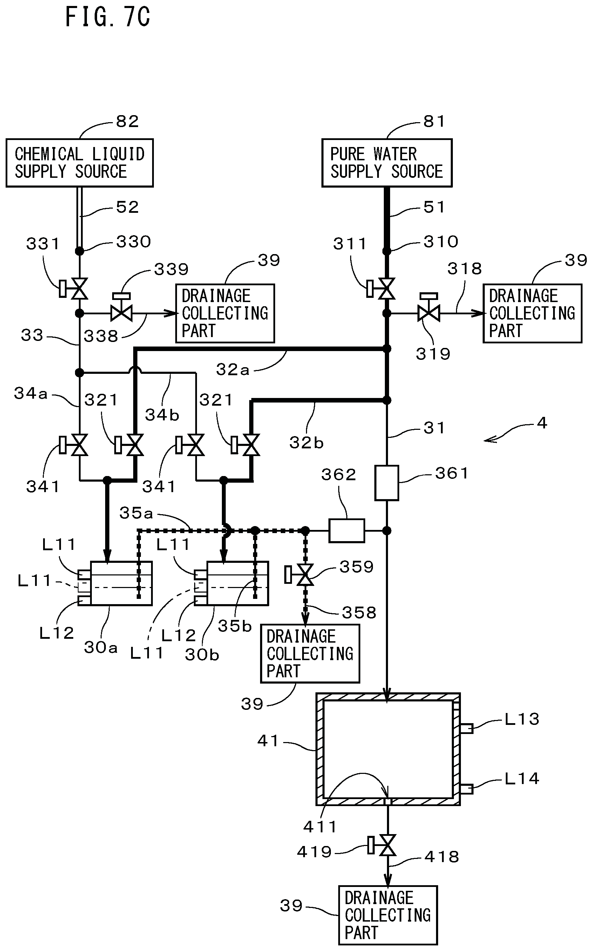

After the flow of the pure water in the pure water introduction line 31 has continued for a predetermined time, the open/close valve of the flow rate adjustment part 361 is closed and the respective valves 321 of the pure water branch lines 32a and 32b are opened. As indicated by a thick solid line in FIG. 7C, the pure water thereby flows into the pure water branch lines 32a and 32b from the pure water supply source 81 through the primary-side connecting pipe 51 and part of the pure water introduction line 31 and the pure water is supplied into the auxiliary tanks 30a and 30b. At that time, in each of the auxiliary tanks 30a and 30b, the operator has moved the upper level sensor L11 to a position between a normal position in the substrate processing and a bottom surface thereof (e.g., a substantially central position therebetween, and hereinafter, referred to as a "first position"). In FIG. 7C, the upper level sensor L11 disposed at the first position is indicated by a two-dot chain line. Further, the normal position in the substrate processing may be any position below the top surface in each of the auxiliary tanks 30a and 30b, and the first position may be any position above the bottom surface and below the normal position (the same applies to a normal position of the storage tank 41 and a first position thereof, respectively). When a liquid surface of the pure water inside each auxiliary tank 30a or 30b reaches the position of the upper level sensor L11 (i.e., when the pure water is pooled up to the first position of each auxiliary tank 30a or 30b), the valve 321 of the pure water branch line 32a or 32b is closed and the supply of the pure water from the pure water supply source 81 into the auxiliary tank 30a or 30b is thereby stopped.

Subsequently, the inside of each of the auxiliary tanks 30a and 30b is pressurized and the pure water inside the auxiliary tanks 30a and 30b is discharged through the chemical liquid supply lines 35a and 35b, respectively. During the discharge of the pure water, the valve 359 of the liquid exhaust line 358 is opened and the pure water flowing in the chemical liquid supply lines 35a and 35b is discharged to the drainage collecting part 39 through the liquid exhaust line 358. In FIG. 7C, flow paths of the pure water from the auxiliary tanks 30a and 30b to the drainage collecting part 39 are indicated by thick broken lines, respectively. Further, the open/close valve of the flow rate adjustment part 362 has been closed. When a predetermined time has elapsed since the liquid surface of the pure water inside each of the auxiliary tanks 30a and 30b reaches below the lower level sensor L12 (i.e., since the output of the lower level sensor L12 indicates that the liquid is not detected), it is determined that all the pure water inside the auxiliary tanks 30a and 30b has been discharged, and the valve 359 of the liquid exhaust line 358 is closed. In the present specification, "the discharge of all the liquid" has only to be regarded as that on the basis of the output of the sensor or the like, and it is not necessary that all the liquid is completely discharged.

In the auxiliary tanks 30a and 30b, the pooling of the pure water up to the first position and the discharge of all the pure water inside the auxiliary tanks 30a and 30b are repeated a plurality of times. A first cleaning for cleaning a portion below the first position of each of the auxiliary tanks 30a and 30b is thereby performed (Step S14). The pooling and the discharge of the pure water in the first cleaning of each of the auxiliary tanks 30a and 30b may be performed only one time.

After the first cleaning of the auxiliary tanks 30a and 30b is completed, the operator returns the upper level sensor L11 to the normal position in the substrate processing, which is positioned above the first position (a position of the upper level sensor L11 indicated by the solid line in FIG. 7C, and hereinafter, referred to as a "second position"). Further, the second position may be any position below the top surface of each of the auxiliary tanks 30a and 30b and above the first position (the same applies to the second position of the storage tank 41). Then, like in the first cleaning, the pure water is supplied into the auxiliary tanks 30a and 30b from the pure water supply source 81. When the liquid surface of the pure water inside each auxiliary tank 30a or 30b reaches the position of the upper level sensor L11 (the second position), the supply of the pure water from the pure water supply source 81 into the auxiliary tank 30a or 30b is stopped. Subsequently, the pure water inside the auxiliary tanks 30a and 30b is discharged to the drainage collecting part 39 through the chemical liquid supply lines 35a and 35b, respectively, and the liquid exhaust line 358. When a predetermined time has elapsed since the liquid surface of the pure water inside each of the auxiliary tanks 30a and 30b reaches below the lower level sensor L12, it is determined that all the pure water inside the auxiliary tanks 30a and 30b has been discharged, and the valve 359 of the liquid exhaust line 358 is closed.

In the auxiliary tanks 30a and 30b, the pooling of the pure water up to the second position and the discharge of all the pure water inside the auxiliary tanks 30a and 30b are repeated a plurality of times. A second cleaning for cleaning a portion above the first position of each of the auxiliary tanks 30a and 30b (exactly, a portion between the first position and the second position) is thereby performed (Step S15). The pooling and the discharge of the pure water in the second cleaning of each of the auxiliary tanks 30a and 30b may be performed only one time.

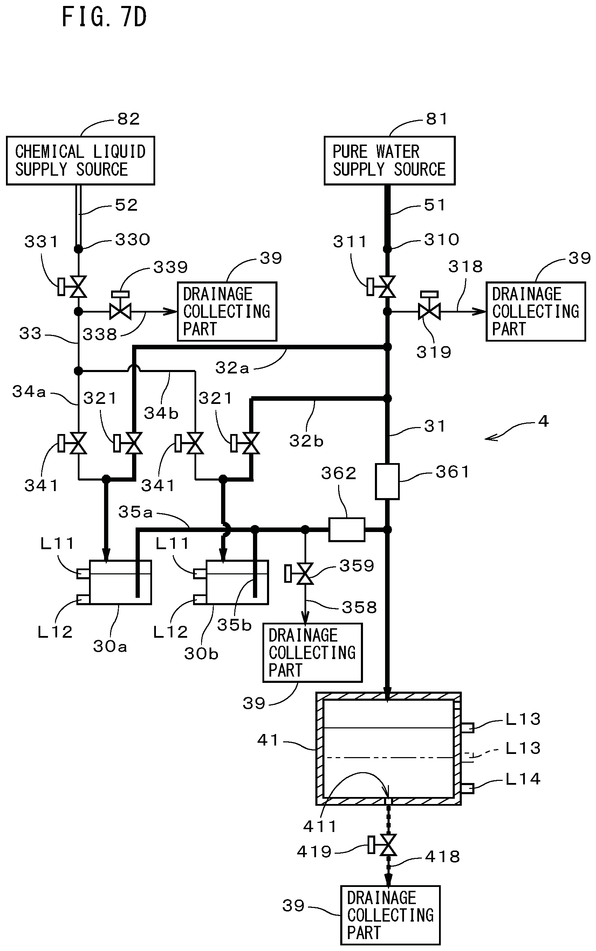

After the second cleaning of the auxiliary tanks 30a and 30b is completed, the pure water is supplied into the auxiliary tanks 30a and 30b from the pure water supply source 81. When the liquid surface of the pure water reaches the position of the upper level sensor L11, the supply of the pure water from the pure water supply source 81 into the auxiliary tank 30a or 30b is stopped. Further, the respective open/close valves of the flow rate adjustment parts 361 and 362 are opened. As indicated by a thick solid line in FIG. 7D, the pure water flowing in the pure water introduction line 31 and the pure water flowing in the chemical liquid supply line 35a are thereby mixed together and supplied into the storage tank 41. Furthermore, in each auxiliary tank 30a or 30b, when the liquid surface of the pure water reaches below the lower level sensor L12, the pure water is supplied (replenished) into the auxiliary tank 30a or 30b from the pure water supply source 81. The same applies to the following.

In the storage tank 41, the operator has moved the upper level sensor L13 to a position between the normal position in the substrate processing and the bottom surface thereof (e.g., a substantially central position therebetween, and hereinafter, referred to as the "first position"). In FIG. 7D, the upper level sensor L13 disposed at the first position is indicated by a two-dot chain line. When a liquid surface of the pure water inside the storage tank 41 reaches the position of the upper level sensor L13 (i.e., when the pure water is pooled up to the first position of the storage tank 41), the respective open/close valves of the flow rate adjustment parts 361 and 362 are closed and the supply of the pure water into the storage tank 41 is thereby stopped. In the processing liquid supply line 4, a flow path on the upstream side relative to the storage tank 41 (in the exemplary case shown in FIG. 7D, the pure water introduction line 31, the pure water branch lines 32a and 32b, the auxiliary tanks 30a and 30b, and the chemical liquid supply lines 35a and 35b) is already cleaned. Therefore, even when the pure water is pooled inside the storage tank 41, contamination of the inside of the storage tank 41 with the particles deposited on the flow path on the upstream side is more reliably suppressed.

Subsequently, the valve 419 of the liquid exhaust line 418 is opened and the pure water inside the storage tank 41 is discharged to the drainage collecting part 39 through the liquid exhaust line 418. In FIG. 7D, a flow path of the pure water from the storage tank 41 to the drainage collecting part 39 are indicated by a thick broken line. When a predetermined time has elapsed since the liquid surface of the pure water inside the storage tank 41 reaches below the lower level sensor L14 (i.e., since the output of the lower level sensor L14 indicates that the liquid is not detected), it is determined that all the pure water inside the storage tank 41 has been discharged, and the valve 419 of the liquid exhaust line 418 is closed.

In the storage tank 41, the pooling of the pure water up to the first position and the discharge of all the pure water inside the storage tank 41 are repeated a plurality of times. The first cleaning for cleaning a portion below the first position of the storage tank 41 is thereby performed (Step S16). The pooling and the discharge of the pure water in the first cleaning of the storage tank 41 may be performed only one time.

After the first cleaning of the storage tank 41 is completed, the operator returns the upper level sensor L13 to the normal position in the substrate processing, which is positioned above the first position (a position of the upper level sensor L13 indicated by the solid line in FIG. 7D, and hereinafter, referred to as the "second position"). Then, like in the first cleaning, the pure water is supplied into the storage tank 41. When the liquid surface of the pure water inside the storage tank 41 reaches the position of the upper level sensor L13 (the second position), the supply of the pure water into the storage tank 41 is stopped. Subsequently, the pure water inside the storage tank 41 is discharged to the drainage collecting part 39 through the liquid exhaust line 418. When a predetermined time has elapsed since the liquid surface of the pure water inside the storage tank 41 reaches below the lower level sensor L14, it is determined that all the pure water inside the storage tank 41 has been discharged, and the valve 419 of the liquid exhaust line 418 is closed.

In the storage tank 41, the pooling of the pure water up to the second position and the discharge of all the pure water inside the storage tank 41 are repeated a plurality of times. The second cleaning for cleaning a portion above the first position of the storage tank 41 (exactly, a portion between the first position and the second position) is thereby performed (Step S17). The pooling and the discharge of the pure water in the second cleaning of the storage tank 41 may be performed only one time.

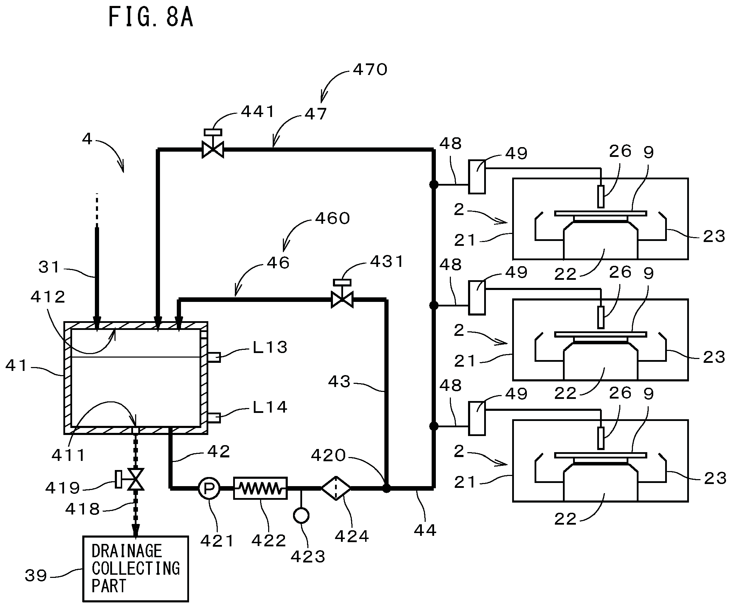

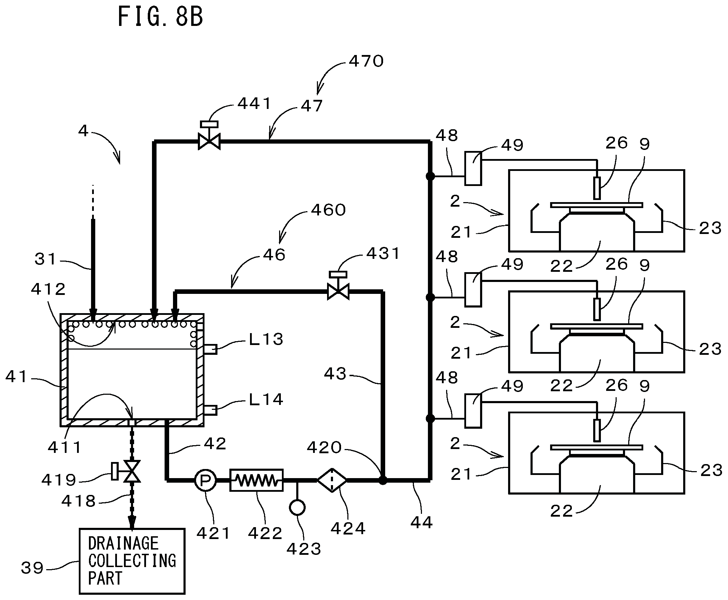

FIGs. 8A and 8B are views each used for explaining the apparatus cleaning process and corresponds to FIG. 2. After the second cleaning of the storage tank 41 is completed, the pure water is pooled up to the second position inside the storage tank 41. Subsequently, by opening the valve 431 of the first return line 43 and the valve 441 of the second return line 44 and starting the liquid feed operation of the pump 421, the pure water inside the storage tank 41 is introduced into the take-out line 42. The flow of the pure water in the take-out line 42 branches out into the first return line 43 and the second return line 44 at the node 420. The pure water flowing into the first return line 43 flows to an end portion on the opposite side to the node 420 and is returned into the storage tank 41. The pure water flowing into the second return line 44 also flows to an end portion on the opposite side to the node 420 and is returned into the storage tank 41. In FIG. 8A, the first circulation line 46 (the take-out line 42 and the first return line 43) and the second circulation line 47 (the take-out line 42 and the second return line 44) in which the pure water flows are indicated by thick solid lines.

Thus, the pure water circulates in the first circulation flow path 460 including the storage tank 41 and the first circulation line 46 and also circulates in the second circulation flow path 470 including the storage tank 41 and the second circulation line 47. At that time, the temperature (hereinafter, referred to as a "first temperature") of the pure water circulating in the first circulation flow path 460 and the second circulation flow path 470 is relatively low. In the present exemplary process, since the heater 422 is in an OFF state, the first temperature is a room temperature. In the processing liquid supply line 4, since a flow path on the upstream side relative to the first circulation flow path 460 and the second circulation flow path 470 (in the exemplary case shown in FIG. 8A, the storage tank 41, the pure water introduction line 31, and the like) is already cleaned, contamination of the first circulation flow path 460 and the second circulation flow path 470 with the particles deposited on the flow path on the upstream side is more reliably suppressed.

After the circulation of the pure water in the first circulation flow path 460 and the second circulation flow path 470 has continued for a predetermined time, the liquid feed operation of the pump 421 is stopped. The circulation of the pure water in the first circulation flow path 460 and the second circulation flow path 470 is thereby stopped. Further, the valve 419 of the liquid exhaust line 418 is opened, and the pure water inside the storage tank 41 is discharged to the drainage collecting part 39 through the liquid exhaust line 418. In other words, the pure water inside the first circulation flow path 460 and the second circulation flow path 470 is discharged outside the circulation flow path. At this point in time, the respective open/close valves of the flow rate adjustment parts 361 and 362 are closed (see FIG. 7D), and no new pure water is supplied into the storage tank 41. When a predetermined time has elapsed since the liquid surface of the pure water inside the storage tank 41 reaches below the lower level sensor L14, it is determined that all the pure water inside the storage tank 41 has been discharged, and the valve 419 of the liquid exhaust line 418 is closed.

Thus, a first circulation cleaning for cleaning the first circulation flow path 460 and the second circulation flow path 470 is performed by circulating the pure water having the first temperature (herein, the room temperature) in the first circulation flow path 460 and the second circulation flow path 470 and discharging the pure water from the first circulation flow path 460 and the second circulation flow path 470 (Step S18). The first circulation cleaning may be repeated a plurality of times (the same applies to second and third circulation cleanings and an additional cleaning described later).

After the first circulation cleaning is completed, the respective open/close valves of the flow rate adjustment parts 361 and 362 are opened and the pure water is pooled up to the second position inside the storage tank 41. Subsequently, like in the first circulation cleaning, by starting the liquid feed operation of the pump 421, the pure water circulates in the first circulation flow path 460 and the pure water also circulates in the second circulation flow path 470. At that time, the pure water circulating in the first circulation flow path 460 and the second circulation flow path 470 is heated by the heater 422 which is in an ON state. In detail, the pure water is heated to a second temperature (e.g., 40 to 60 °C) which is higher than the above-described first temperature and lower than a later-described high-degree cleaning temperature by the control of the heater 422 with the controller 100.

After the circulation of the pure water having the second temperature in the first circulation flow path 460 and the second circulation flow path 470 has continued for a predetermined time, the liquid feed operation of the pump 421 is stopped. Further, the valve 419 of the liquid exhaust line 418 is opened, and the pure water inside the storage tank 41 is discharged to the drainage collecting part 39 through the liquid exhaust line 418. Thus, a second circulation cleaning for cleaning the first circulation flow path 460 and the second circulation flow path 470 is performed by circulating the pure water having the second temperature in the first circulation flow path 460 and the second circulation flow path 470 and discharging the pure water from the first circulation flow path 460 and the second circulation flow path 470 (Step S19). Further, after the second circulation cleaning at the second temperature, a circulation cleaning at a third temperature higher than the second temperature and lower than the high-degree cleaning temperature may be further performed.

After the second circulation cleaning is completed, a not-shown aqueous ammonia supply source is attached to the processing liquid supply line 4. Aqueous ammonia is supplied as an additional cleaning solution into the storage tank 41 from the aqueous ammonia supply source and pooled up to the second position. After that, like in the first and second circulation cleanings, by starting the liquid feed operation of the pump 421, the aqueous ammonia circulates in the first circulation flow path 460 and also circulates in the second circulation flow path 470. With the aqueous ammonia, as compared with the pure water, it becomes easier to peel off the particles deposited on the inside of each of the first circulation flow path 460 and the second circulation flow path 470. The aqueous ammonia circulating in the first circulation flow path 460 and the second circulation flow path 470 may be heated by the heater 422 which is in the ON state.

In the supply of the aqueous ammonia into the storage tank 41, the aqueous ammonia supply source and the storage tank 41 may be directly connected to each other with another not-shown line, or the aqueous ammonia supply source may be connected to the pure water introduction line 31, the take-out line 42, the first return line 43, the second return line 44. or the like. Further, aqueous ammonia may be supplied into the storage tank 41 through the auxiliary tanks 30a and 30b.

After the circulation of the aqueous ammonia in the first circulation flow path 460 and the second circulation flow path 470 has continued for a predetermined time, the liquid feed operation of the pump 421 is stopped. Further, the valve 419 of the liquid exhaust line 418 is opened, and all the aqueous ammonia inside the storage tank 41 is discharged to the drainage collecting part 39 through the liquid exhaust line 418. Thus, an additional cleaning for cleaning the first circulation flow path 460 and the second circulation flow path 470 is performed by circulating the aqueous ammonia in the first circulation flow path 460 and the second circulation flow path 470 and discharging the aqueous ammonia from the first circulation flow path 460 and the second circulation flow path 470 (Step S20).

In the additional cleaning, an additional cleaning solution other than the aqueous ammonia may be used. It is preferable that the additional cleaning solution should be an acid or alkaline liquid, and it thereby becomes possible to thoroughly clean the first circulation flow path 460 and the second circulation flow path 470. In the additional cleaning, ammonia contained in the aqueous ammonia inside the storage tank 41 is volatilized and some substances containing ammonia are sometimes deposited on the top surface 412 of the storage tank 41 and a portion on the side surface of the storage tank 41 above the liquid surface (hereinafter, referred to as "top surface 412 and the like"). A reaction product of the substance and the chemical liquid or the like may become particles. Further, particles are sometimes deposited on the top surface 412 and the like. In the apparatus cleaning process, cleaning of the top surface 412 and the like of the storage tank 41 is performed subsequent to the additional cleaning. In the present exemplary process, pure water is used as the cleaning solution in the cleaning of the top surface 412 and the like.

Specifically, after the additional cleaning is completed, the aqueous ammonia supply source is removed from the processing liquid supply line 4. Further, the respective open/close valves of the flow rate adjustment parts 361 and 362 are opened, the pure water serving as the cleaning solution is pooled up to the second position inside the storage tank 41. Subsequently, like in the first and second circulation cleanings, by starting the liquid feed operation of the pump 421, the pure water circulates in the first circulation flow path 460 and also circulates in the second circulation flow path 470. At that time, the pure water circulating in the first circulation flow path 460 and the second circulation flow path 470 is heated by the heater 422 which is the ON state. In detail, the pure water is heated to a temperature (hereinafter, referred to as a "high-degree cleaning temperature") which is higher than the first temperature and the second temperature by the control of the heater 422 with the controller 100. The high-degree cleaning temperature is, for example, not lower than 65 °C, preferably not lower than 70 °C, and more preferably not lower than 75 °C. An upper limit of the high-degree cleaning temperature is, for example, the boiling point of the cleaning solution (herein, the pure water). In the following description, the cleaning solution at the high-degree cleaning temperature is referred to as a "high-temperature cleaning solution".

The high-temperature cleaning solution is continuously supplied into the storage tank 41 from the first circulation line 46 and the second circulation line 47. Inside the storage tank 41, a vapor of the cleaning solution is generated and the cleaning solution is condensed on the top surface 412 and the like as indicated by small circles in FIG. 8B. When an unnecessary substance such as the substances containing ammonia, particles, or the like is deposited on the top surface 412 and the like, the unnecessary substance is dissolved or mixed into the cleaning solution, and a lump of the cleaning solution (a droplet or the like) containing the unnecessary substance drops into the cleaning solution stored inside the storage tank 41 or goes along the side surface or the like to flow into the cleaning solution. Thus, the top surface 412 and the like is cleaned with the cleaning solution (Step S21).

In an operation of Step S21, it becomes possible to replace the additional cleaning solution remaining in the first circulation flow path 460 and the second circulation flow path 470 with the pure water which is the high-temperature cleaning solution and also peel off and remove the particles adhering to the first circulation flow path 460 and the second circulation flow path 470 with the high-temperature cleaning solution. When the temperature of the high-temperature cleaning solution ranges from 75 °C to 85 °C, it is possible to generate a sufficient amount of vapor of the cleaning solution while avoiding bumping of the pure water or a malfunction of the flowmeter or the like. After the supply of the high-temperature cleaning solution into the storage tank 41 (the circulation of the high-temperature cleaning solution in the first circulation flow path 460 and the second circulation flow path 470) has continued for a predetermined time, the liquid feed operation of the pump 421 is stopped. Further, the valve 419 of the liquid exhaust line 418 is opened, and all the high-temperature cleaning solution inside the storage tank 41 is discharged to the drainage collecting part 39 through the liquid exhaust line 418.

The cleaning of the top surface 412 and the like of the storage tank 41 with the high-temperature cleaning solution is effective when the substance caused by the additional cleaning solution is deposited on the top surface 412 and the like. In other words, the substance contained in the additional cleaning solution has a vapor pressure at the room temperature which is higher than that of pure water and has a boiling point lower than that of pure water. Specifically, when the substance is a volatile substance having a volatility higher than that of pure water, it is preferable that the cleaning of the top surface 412 and the like should be performed with the high-temperature cleaning solution. When the additional cleaning solution is an aqueous solution, it becomes possible to efficiently remove the substance deposited on the top surface 412 and the like of the storage tank 41 with the high-temperature cleaning solution which is water. The cleaning of the top surface 412 and the like of the storage tank 41 may be repeated a plurality of times.

After the cleaning of the top surface 412 and the like of the storage tank 41 is completed, the respective open/close valves of the flow rate adjustment parts 361 and 362 are opened and the pure water is pooled up to the second position inside the storage tank 41. Subsequently, by starting the liquid feed operation of the pump 421, the pure water circulates in the first circulation flow path 460 and the pure water also circulates in the second circulation flow path 470. At that time, the heater 422 may be in the ON state or the OFF state. Subsequently, by operating the mixing valve 49, the pure water inside the second circulation flow path 470 flows into the branch line 48 and is supplied to the mixing valve 49.

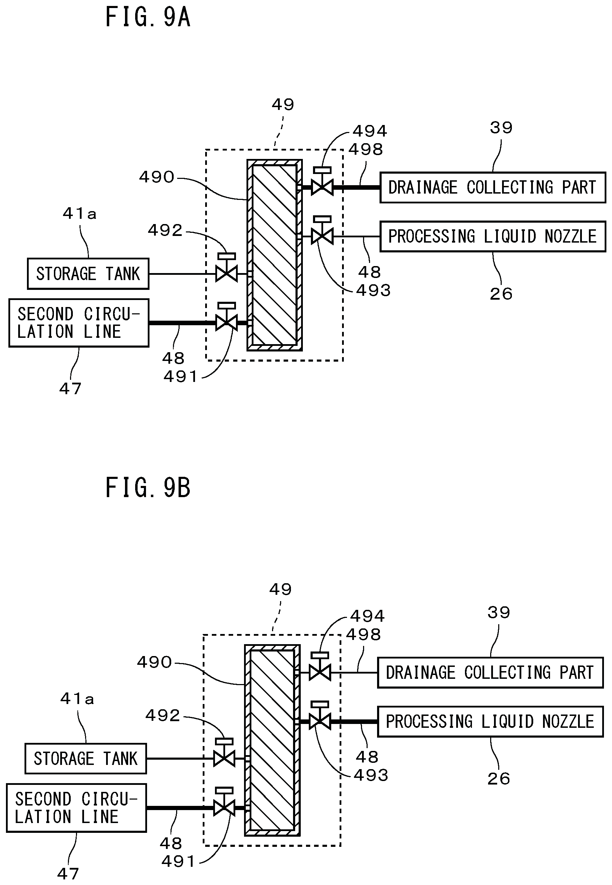

FIGs. 9A and 9B are views each used for explaining the apparatus cleaning process and corresponds to FIG. 4. In the mixing valve 49, by opening the first valve 491, as indicated by a thick solid line in FIG. 9A, the pure water inside the second circulation flow path 470 is supplied into the mixing body 490 through the branch line 48. Further, by opening the fourth valve 494, the pure water inside the mixing body 490 is discharged to the drainage collecting part 39 through the liquid exhaust line 498. The inside of the mixing body 490 is thereby cleaned (Step S22). In FIG. 9A, hatching of the inside of the mixing body 490 indicates that the pure water fills the inside thereof (the same applies to FIG. 9B). In the processing liquid supply line 4, since most part of the flow path on the upstream side relative to the mixing valve 49 (herein, the second circulation flow path 470, the storage tank 41, and the like) is already cleaned, contamination of the mixing valve 49 with the particles deposited on the flow path on the upstream side is more reliably suppressed. Though the amount of pure water inside the storage tank 41 is reduced in an operation of Step S22, when the liquid surface of the pure water inside the storage tank 41 reaches below the lower level sensor L14, the flow rate adjustment parts 361 and 362 are controlled to replenish the pure water into the storage tank 41 (the same applies to Step S23 described later).

After the supply of the pure water into the mixing body 490 and the discharge of the pure water inside the mixing body 490 have continued for a predetermined time, the fourth valve 494 is closed and the third valve 493 is opened. As indicated by a thick solid line in FIG. 9B, the pure water inside the mixing body 490 is thereby supplied into the processing liquid nozzle 26. The pure water ejected from the processing liquid nozzle 26 is received by the cup part 23 and discharged to outside the chamber 21 through the drainage port (see FIG. 2). The processing liquid nozzle 26 is thereby cleaned with the pure water (Step S23). In the processing liquid supply line 4, since most part of the flow path on the upstream side relative to the processing liquid nozzle 26 (herein, the mixing valve 49, the second circulation flow path 470, and the like) is already cleaned, contamination of the mixing valve 49 with the particles deposited on the flow path on the upstream side is more reliably suppressed. Actually, in the process of Steps S22 and S23, the whole branch line 48 is cleaned.

After the ejection of the pure water from the processing liquid nozzle 26 has continued for a predetermined time, by closing the first valve 491 and the third valve 493 of the mixing valve 49, the ejection of the pure water from the processing liquid nozzle 26 is stopped. Thus, the apparatus cleaning process shown in FIG. 6 is completed. The process of Steps S22 and S23 may be performed on (all) the plurality of branch lines 48 at the same time, or may be performed individually thereon. During the cleaning of the processing liquid nozzle 26 in the present exemplary process, inside the chamber 21, no substrate 9 (product substrate) is disposed but a substrate which is not to become a semiconductor product (a so-called dummy substrate) may be disposed.

Actually, the apparatus cleaning process using the chemical liquid from the chemical liquid supply source 82 is also performed in the same manner as that in the apparatus cleaning process using the pure water from the pure water supply source 81. Specifically, first, the operator connects the introduction port 330 of the chemical liquid introduction line 33 to the chemical liquid supply source 82 with the primary-side connecting pipe 52 which are shown in FIG. 3 (Step S11). Subsequently, in a state where the valve 331 in the vicinity of the introduction port 330 and the valve 339 of the liquid exhaust line 338 are opened, the chemical liquid is supplied into the primary-side connecting pipe 52 from the chemical liquid supply source 82. The chemical liquid flows into the liquid exhaust line 338 through the primary-side connecting pipe 52 and the introduction port 330 and is discharged to the drainage collecting part 39. Thus, the primary-side connecting pipe 52 is cleaned (Step S12).

Subsequently, the valve 339 of the liquid exhaust line 338 is closed and the respective valves 341 of the chemical liquid branch lines 34a and 34b are opened. The chemical liquid thereby flows into the chemical liquid branch lines 34a and 34b from the chemical liquid supply source 82 through the primary-side connecting pipe 52 and the chemical liquid introduction line 33 and the chemical liquid is supplied into the auxiliary tanks 30a and 30b. At that time, in each of the auxiliary tanks 30a and 30b, the operator has disposed the upper level sensor L11 at the first position (see the upper level sensor L11 indicated by the two-dot chain line in FIG. 7C). When the liquid surface of the chemical liquid inside each auxiliary tank 30a or 30b reaches the position of the upper level sensor L11, by closing the valve 341 of the chemical liquid branch line 34a or 34b, the supply of the chemical liquid into the auxiliary tank 30a or 30b from the chemical liquid supply source 82 is stopped.

Subsequently, the inside of each of the auxiliary tanks 30a and 30b is pressurized and the chemical liquid inside the auxiliary tanks 30a and 30b is discharged to the chemical liquid supply lines 35a and 35b, respectively. During the discharge of the chemical liquid, the valve 359 of the liquid exhaust line 358 is opened and the chemical liquid flowing in the chemical liquid supply lines 35a and 35b is discharged to the drainage collecting part 39 through the liquid exhaust line 358. After all the chemical liquid inside the auxiliary tanks 30a and 30b has been discharged, the valve 359 of the liquid exhaust line 358 is closed. In the auxiliary tanks 30a and 30b, the pooling of the chemical liquid up to the first position and the discharge of all the chemical liquid inside the auxiliary tanks 30a and 30b are repeated a plurality of times. The first cleaning for cleaning a portion below the first position of each of the auxiliary tanks 30a and 30b is thereby performed (Step S14). The pooling and the discharge of the chemical liquid in the first cleaning of each of the auxiliary tanks 30a and 30b may be performed only one time. Further, in the apparatus cleaning process using the chemical liquid, Step S13 in FIG. 6 is omitted.

After the first cleaning of the auxiliary tanks 30a and 30b is completed, the operator returns the upper level sensor L11 to the normal position (i.e., the second position) in the substrate processing, which is positioned above the first position. When the chemical liquid is supplied from the chemical liquid supply source 82 into each auxiliary tank 30a or 30b and the liquid surface of the chemical liquid reaches the second position, the supply of the chemical liquid from the chemical liquid supply source 82 into the auxiliary tank 30a or 30b is stopped. Subsequently, the chemical liquid inside the auxiliary tanks 30a and 30b is discharged to the drainage collecting part 39 through the chemical liquid supply lines 35a and 35b, respectively, and the liquid exhaust line 358. In the auxiliary tanks 30a and 30b, the pooling of the chemical liquid up to the second position and the discharge of all the chemical liquid inside the auxiliary tanks 30a and 30b are repeated a plurality of times. The second cleaning for cleaning a portion above the first position of each of the auxiliary tanks 30a and 30b is thereby performed (Step S15). The pooling and the discharge of the chemical liquid in the second cleaning of each of the auxiliary tanks 30a and 30b may be performed only one time.

After the second cleaning of the auxiliary tanks 30a and 30b is completed, the chemical liquid is supplied into the auxiliary tanks 30a and 30b from the chemical liquid supply source 82. When the liquid surface of the chemical liquid reaches the position of the upper level sensor L11, the supply of the chemical liquid from the chemical liquid supply source 82 into each auxiliary tank 30a or 30b is stopped. Further, the respective open/close valves of the flow rate adjustment parts 361 and 362 are opened. The pure water flowing in the pure water introduction line 31 and the chemical liquid flowing in the chemical liquid supply line 35a are thereby mixed together and the diluted chemical liquid is supplied into the storage tank 41. Furthermore, only the chemical liquid may be supplied into the storage tank 41 while the open/close valve of the flow rate adjustment part 361 remains closed (The same applies to the following).

In the storage tank 41, the operator has moved the upper level sensor L13 to the first position (see the upper level sensor L13 indicated by the two-dot chain line in FIG. 7D). When a liquid surface of the diluted chemical liquid inside the storage tank 41 reaches the position of the upper level sensor L13, the respective open/close valves of the flow rate adjustment parts 361 and 362 are closed, to thereby stop the supply of the diluted chemical liquid into the storage tank 41. Subsequently, the valve 419 of the liquid exhaust line 418 is opened and the diluted chemical liquid inside the storage tank 41 is discharged to the drainage collecting part 39 through the liquid exhaust line 418. After all the diluted chemical liquid inside the storage tank 41 has been discharged, the valve 419 of the liquid exhaust line 418 is closed. In the storage tank 41, the pooling of the diluted chemical liquid up to the first position and the discharge of all the diluted chemical liquid inside the storage tank 41 are repeated a plurality of times. The first cleaning for cleaning a portion below the first position of the storage tank 41 is thereby performed (Step S16). The pooling and the discharge of the diluted chemical liquid in the first cleaning of the storage tank 41 may be performed only one time.

After the first cleaning of the storage tank 41 is completed, the operator returns the upper level sensor L13 to the normal position (i.e., the second position) in the substrate processing, which is positioned above the first position. Like in the above-described process, when the diluted chemical liquid is supplied into the storage tank 41 and the liquid surface of the diluted chemical liquid inside the storage tank 41 reaches the second position, the supply of the diluted chemical liquid into the storage tank 41 is stopped. Subsequently, the diluted chemical liquid inside the storage tank 41 is discharged to the drainage collecting part 39 through the liquid exhaust line 418. In the storage tank 41, the pooling of the diluted chemical liquid up to the second position and the discharge of all the diluted chemical liquid inside the storage tank 41 are repeated a plurality of times. The second cleaning for cleaning a portion above the first position of the storage tank 41 is thereby performed (Step S17). The pooling and the discharge of the diluted chemical liquid in the second cleaning of the storage tank 41 may be performed only one time.

The process of Steps S18 and S23 is the same as that for the apparatus cleaning process using the pure water except that the diluted chemical liquid is used instead of the pure water. Thus, in the apparatus cleaning process shown in FIG. 6, the processing liquid supply line 4 is cleaned with the component liquid (herein, the pure water and the chemical liquid) contained in the processing liquid for the substrate 9. In the apparatus cleaning process using the chemical liquid, some process steps, such as the additional cleaning in Step S20, the process step of cleaning the top surface 412 and the like of the storage tank 41 in Step S21, and the like may be omitted. Further, the apparatus cleaning process using the pure water and the apparatus cleaning process using the chemical liquid may be performed partially in parallel.

In the processing liquid supply line 4 shown in FIG. 3, a supply source of any other component liquid contained in the processing liquid may be further provided to supply the other component liquid into the storage tank 41. For example, the supply source is connected to the storage tank 41 with a primary-side connecting pipe and an introduction line for the other component liquid, not through the auxiliary tank 30a or 30b. In this case, after an introduction port of the introduction line for the other component liquid and the supply source are connected to each other with the primary-side connecting pipe (Step S11), by discharging the other component liquid to the outside through a liquid exhaust line provided in the vicinity of the introduction port, the primary-side connecting pipe is cleaned (Step S12). After the primary-side connecting pipe is cleaned, the other component liquid is supplied into the storage tank 41 from the supply source through the primary-side connecting pipe and the introduction line, and the introduction line and the like are cleaned. As a matter of course, the pure water supply source 81 and the chemical liquid supply source 82 shown in FIG. 3 may be also connected to the storage tank 41 not through the auxiliary tank 30a or 30b, respectively.

Further, the apparatus cleaning process shown in FIG. 6 may be performed on a processing liquid supply line including no circulation flow path. In this case, for example, one end of a line (the branch line 48 in FIG. 2) is connected to the processing liquid nozzle 26 and the other end thereof is directly connected to the storage tank 41. Further, in the branch line 48, the mixing valve 49 may be changed to an open/close valve or the like. In this case, cleaning of the mixing valve 49 in Step S22 is omitted. The configuration of the processing liquid supply line may be changed variously, and the apparatus cleaning process may be also changed in accordance with the processing liquid supply line as appropriate.

As described above, the apparatus cleaning process shown in FIG. 6 includes a pipe cleaning method of the substrate processing apparatus 10, and the substrate processing apparatus 10 includes the holder (the spin chuck 22 in the above description) for holding the substrate 9, the processing liquid nozzle 26 for ejecting the processing liquid toward the substrate 9, and the processing liquid supply line 4 for supplying the processing liquid to the processing liquid nozzle 26. At the installation location where the substrate processing apparatus 10 is installed, provided is the supply source (the pure water supply source 81 or the chemical liquid supply source 82 in the above description) of the component liquid contained in the processing liquid. The pipe cleaning method includes a connecting step of connecting the introduction port 310 or 330 of the processing liquid supply line 4 to the supply source with the primary-side connecting pipe 51 or 52, respectively, a first cleaning step of introducing the component liquid to the primary-side connecting pipe 51 or 52 from the supply source and discharging the component liquid to the outside from the liquid exhaust line 318 or 338 provided in the vicinity of the introduction port 310 or 330, to thereby clean the primary-side connecting pipe 51 or 52, and a second cleaning step of introducing the component liquid into the processing liquid supply line 4 through the primary-side connecting pipe 51 or 52, to thereby clean the processing liquid supply line 4 after the first cleaning step.

Thus, by causing the component liquid to flow into the processing liquid supply line 4 after cleaning of the primary-side connecting pipe 51 or 52, it is possible to suppress the particles peeled off from the primary-side connecting pipe 51 or 52 from entering a wide range of the processing liquid supply line 4. As a result, in the substrate processing apparatus 10, it is possible to suppress occurrence of any trouble due to the particles. Though a mixed solution (diluted chemical liquid) of the plurality of component liquids is used as the processing liquid in the above-described exemplary process, the component liquid itself may be used as the processing liquid in the substrate processing apparatus 10.

Preferably, the processing liquid supply line 4 includes the storage tank 41 which is capable of storing the liquid and has the drain port 411. The second cleaning step includes a storage tank cleaning step of cleaning the storage tank 41 by filling the component liquid into the storage tank 41 and discharging the component liquid from the drain port 411 to the outside. It is thereby possible to appropriately remove the particles deposited on the storage tank 41. Further, by performing the storage tank cleaning step before the component liquid flows into the downstream side (on the side of the processing liquid nozzle 26) relative to the storage tank 41 in the processing liquid supply line 4, it is possible to suppress the particles from entering the downstream side relative to the storage tank 41.

Preferably, the processing liquid supply line 4 further includes the circulation line (the first circulation line 46 and the second circulation line 47 in the above description) for taking out the liquid inside the storage tank 41 from one end thereof and returning the liquid into the storage tank 41 from the other end thereof. Further, the circulation flow path (the first circulation flow path 460 and the second circulation flow path 470 in the above description) in which the liquid circulate is formed by using the storage tank 41 and the circulation line. The second cleaning step further includes a circulation flow path cleaning step of cleaning the circulation flow path by circulating the component liquid in the circulation flow path after the storage tank cleaning step. Thus, by cleaning the storage tank 41 before cleaning of the circulation flow path, it is possible to suppress the particles peeled off from the storage tank 41 from entering the circulation flow path. Further, in the cleaning of the circulation flow path in which the component liquid circulates, it is possible to reduce the amount of component liquid to be consumed.

Preferably, the processing liquid supply line 4 further includes the branch line 48 which branches off from the circulation line and is connected to the processing liquid nozzle 26. Further, the second cleaning step further includes a process step of cleaning the processing liquid nozzle 26 by introducing the component liquid into the branch line 48 after the circulation flow path cleaning step. Thus, by cleaning the circulation flow path before the cleaning of the processing liquid nozzle 26, it is possible to suppress the particles peeled off from the circulation flow path from entering the processing liquid nozzle 26.

In a case where the processing liquid supply line 4 further includes the heater 422 for heating the liquid flowing in the circulation flow path, it is preferable that the circulation flow path cleaning step should include the first circulation cleaning of cleaning the circulation flow path by circulating the component liquid having the first temperature in the circulation flow path and the second circulation cleaning of cleaning the circulation flow path by circulating the component liquid having the second temperature higher than the first temperature in the circulation flow path after the first circulation cleaning. Thus, by sequentially increasing the temperature of the component liquid, it is possible to peel off the particles deposited on the circulation flow path little by little. As a result, it is possible to suppress a large amount of particles from being peeled off all at once to cause redeposition of the particles on an unintended portion of the processing liquid supply line 4.

In a case or the like where the processing liquid supply line 4 does not include any circulation line, the second cleaning step may further include a process step of cleaning the processing liquid nozzle 26 by supplying the component liquid stored in the storage tank 41 to the processing liquid nozzle 26 after the storage tank cleaning step. By cleaning the storage tank 41 before the cleaning of the processing liquid nozzle 26, it is possible to suppress the particles peeled off from the storage tank 41 from entering the processing liquid nozzle 26. As a matter of course, in a case where the processing liquid supply line 4 includes the circulation line, the processing liquid nozzle 26 may be cleaned by supplying the component liquid to the processing liquid nozzle 26 without performing the circulation flow path cleaning step after the storage tank cleaning step.

Preferably, the storage tank cleaning step includes the first cleaning for cleaning a portion below the first position of the storage tank 41 by filling the component liquid up to the first position in the up-and-down direction inside the storage tank 41 and discharging the component liquid from the drain port 411 to the outside, and the second cleaning for cleaning a portion above the first position of the storage tank 41 by filling the component liquid up to the second position above the first position inside the storage tank 41 and discharging the component liquid from the drain port 411 to the outside after the first cleaning. It is thereby possible to peel off the particles deposited on the storage tank 41 little by little. As a result, it is possible to suppress a large amount of particles from being peeled off all at once and suppress the particles from entering the pipe connected to the storage tank 41. The storage tank cleaning step including the above-described first cleaning and second cleaning may be performed independently of any other cleaning step. Further, the same applies to a case where the cleaning method is adopted for the auxiliary tanks 30a and 30b.

In the substrate processing apparatus 10, as described above, the processing liquid supply line 4 may further include the auxiliary tank 30a or 30b capable of storing a liquid. The liquid inside the auxiliary tank 30a or 30b can be supplied to the storage tank 41. In this case, it is preferable that the second cleaning step should further include a process step of cleaning the auxiliary tank 30a or 30b before the storage tank cleaning step. It is thereby possible to suppress the particles peeled off from the auxiliary tank 30a or 30b from entering the storage tank 41.

Further, the processing liquid supply line 4 may include the mixing valve 49 for mixing together two or more types of liquids supplied therein. Among the plurality of valves provided in the mixing valve 49, the first valve 491 is provided at the inflow port of the component liquid, the second valve 492 is provided at the inflow port of another liquid, the third valve 493 is provided at the outflow port to the processing liquid nozzle 26, and the fourth valve 494 is provided at the drain port to the outside. In this case, it is preferable that the second cleaning step should include a mixing valve cleaning step of cleaning the mixing valve 49 by supplying the component liquid into the mixing valve 49 and discharging the component liquid from the above-described drain port, and a processing liquid nozzle cleaning step of cleaning the processing liquid nozzle 26 by supplying the component liquid to the processing liquid nozzle 26 from the mixing valve 49 after the mixing valve cleaning step. By cleaning the mixing valve 49 before the cleaning of the processing liquid nozzle 26, it is possible to suppress the particles peeled off from the mixing valve 49 from entering the processing liquid nozzle 26.

Though the top surface 412 and the like of the storage tank 41 are cleaned by supplying the high-temperature cleaning solution into the storage tank 41 in Step S21 of FIG. 6, the high-temperature cleaning solution flowing in the processing liquid supply line 4 may be supplied into the chamber 21. Specifically, the high-temperature cleaning solution flowing in the processing liquid supply line 4 is ejected from the processing liquid nozzle 26 to be supplied into the chamber 21. A vapor of the cleaning solution is thereby generated inside the chamber 21, and the cleaning solution is condensed on the top surface and the side surface of the chamber 21, an outer surface of the processing liquid nozzle 26 disposed inside the chamber 21, and the like. As a result, it becomes possible to clean the top surface and the like of the chamber 21.

Thus, in the cleaning method (the above-described apparatus cleaning method) of the substrate processing apparatus 10, the substrate processing apparatus 10 includes the holder (the spin chuck 22 in the above description) for holding the substrate 9, the processing liquid nozzle 26 for ejecting the processing liquid toward the substrate 9, the processing liquid supply line 4 for supplying the processing liquid to the processing liquid nozzle 26, and the chamber 21 inside which the holder and the processing liquid nozzle 26 are disposed. Further, the processing liquid supply line 4 includes the storage tank 41 capable of storing a liquid therein. The above-described cleaning method includes the connecting step of connecting the supply source (the pure water supply source 81 or the chemical liquid supply source 82 in the above description) of a predetermined cleaning solution to the processing liquid supply line 4, and a top-surface-and-the-like cleaning step of causing the high-temperature cleaning solution obtained by heating the cleaning solution up to a temperature higher than the room temperature to flow into the processing liquid supply line 4 to supply the high-temperature cleaning solution to the target space which is the inside of the storage tank 41 or the chamber 21, to thereby generate a vapor of the cleaning solution inside the target space and condense the cleaning solution on the top surface and/or the side surface of the target space. Thus, by using the high-temperature cleaning solution, it is possible to easily clean the top surface and/or the side surface of the target space with the cleaning solution.

In a case where the above-described target space is the storage tank 41, in the top-surface-and-the-like cleaning step, it is preferable to fill the high-temperature cleaning solution into the storage tank 41 up to a position lower than the breathing hole 416 provided in the storage tank 41. It is thereby possible to prevent the high-temperature cleaning solution from leaking outside in the top-surface-and-the-like cleaning step. Depending on the structure of the storage tank 41, the breathing hole 416 may be omitted.

Preferably, the processing liquid supply line 4 further includes the circulation line (the first circulation line 46 and the second circulation line 47 in the above description) for forming the circulation flow path (the first circulation flow path 460 and the second circulation flow path 470, respectively, in the above description) in which the liquid circulates, together with the storage tank 41, by taking out the liquid inside the storage tank 41 from one end thereof and returning the liquid into the storage tank 41 from the other end thereof, and the heater 422 for heating the liquid flowing in the circulation flow path. Then, in the top-surface-and-the-like cleaning step, the cleaning solution circulating in the circulation flow path is heated by the heater 422. It is thereby possible to easily prepare the high-temperature cleaning solution. Further, it is possible to thoroughly clean the circulation line while reducing the amount of cleaning solution to be consumed. Furthermore, it is possible to perform the cleaning of the top surface and the like of the target space and the cleaning of the circulation line in parallel, in other words, possible to efficiently clean the substrate processing apparatus 10.

In this case, it is preferable that the above-described cleaning method should further include the process step of cleaning the circulation flow path by circulating the cleaning solution having a temperature lower than that of the high-temperature cleaning solution inside the circulation flow path and discharging the cleaning solution outside the circulation flow path before the top-surface-and-the-like cleaning step. Thus, by cleaning the circulation flow path with the cleaning solution having a low temperature (e.g., the room temperature) before the cleaning using the high-temperature cleaning solution, it is possible to suppress a large amount of particles from being peeled off from the circulation flow path and entering the processing liquid nozzle 26 or the like during the cleaning using the high-temperature cleaning solution.

In the case where the storage tank 41 has the drain port 411, it is preferable that the above-described cleaning method should further include the process step of cleaning the storage tank 41 by filling the cleaning solution having a temperature lower than that of the high-temperature cleaning solution into the storage tank 41 and discharging the cleaning solution from the drain port 411 to the outside before the top-surface-and-the-like cleaning step. Thus, by cleaning the storage tank 41 with the low-temperature cleaning solution before the cleaning using the high-temperature cleaning solution, it is possible to suppress a large amount of particles from being peeled off from the storage tank 41 and entering the processing liquid nozzle 26 or the like during the cleaning using the high-temperature cleaning solution.

Before the top-surface-and-the-like cleaning step, another cleaning solution may be supplied into the storage tank 41. The other cleaning solution is an acid or alkaline liquid. In this case, it is possible to suitably clean the storage tank 41 or the like with acid or alkaline another cleaning solution. Further, the top surface and the like of the target space on which the other cleaning solution is deposited can be appropriately cleaned with the high-temperature cleaning solution. In a case where the cleaning solution is water and the other cleaning solution is an aqueous solution, it is possible to more reliably remove the other cleaning solution deposited on the top surface and the like of the target space.

In the above-described apparatus cleaning process, various modifications can be made.

In the processing liquid supply line 4, for example, by providing a heater or the like between the storage tank 41 and the pure water supply source 81 (or the chemical liquid supply source 82), the second circulation cleaning (Step S19), the cleaning of the top surface 412 and the like of the storage tank 41 (Step S21), or the like may be performed. Further, the pure water supply source 81 may supply a heated cleaning solution (high-temperature cleaning solution or the like) to the processing liquid supply line 4.

The cleaning of the auxiliary tanks 30a and 30b, the cleaning of the storage tank 41, and the circulation cleaning of the circulation flow path may be performed after the top-surface-and-the-like cleaning step or omitted. On the other hand, during the top-surface-and-the-like cleaning step, in order to reduce the amount of particles contained in the cleaning solution and suppress redeposition of the particles onto any unintended portion, it is preferable that the cleaning of the auxiliary tanks 30a and 30b, the cleaning of the storage tank 41, and the circulation cleaning of the circulation flow path should be performed before the top-surface-and-the-like cleaning step.

In the above-described preferred embodiment, though the first circulation flow path 460 and the second circulation flow path 470 are cleaned in parallel (at the same time) in each of Steps S18 and S19 (and Steps S20 and S21), the first circulation flow path 460 and the second circulation flow path 470 may be individually cleaned, or only one of the first circulation flow path 460 and the second circulation flow path 470 may be cleaned. In an exemplary case where the first circulation flow path 460 and the second circulation flow path 470 are individually cleaned, first, the first circulation flow path 460 is cleaned in a state where the valve 431 of the first return line 43 is opened and the valve 441 of the second return line 44 is closed. After that, the second circulation flow path 470 is cleaned in a state where the valve 431 of the first return line 43 is closed and the valve 441 of the second return line 44 is opened.

In the cleaning of the storage tank 41 and the auxiliary tanks 30a and 30b, the storage of the cleaning solution into the tank and the discharge of the cleaning solution from the tank may be performed in parallel. Similarly, in the circulation cleaning of the first circulation flow path 460 and the second circulation flow path 470, the circulation of the cleaning solution in the circulation flow path and the discharge of the cleaning solution from the circulation flow path may be performed in parallel.

The above-described apparatus cleaning process may be performed in the manufacturing location of the substrate processing apparatus 10. Alternatively, the apparatus cleaning process may be performed, after a temporary suspension of the operation (for example, a maintenance or the like), at a resumption of the operation or the like in the substrate processing apparatus 10 which actually performs the substrate processing in the installation location. In this case, the supply source of the cleaning solution (e.g., the pure water supply source 81) may be connected to the processing liquid supply line 4 in advance. On the other hand, during the conveyance from the manufacturing location of the substrate processing apparatus 10 to the installation location thereof, the particles become easier to adhere to the constituent components of the substrate processing apparatus 10. Therefore, it is more preferable that the above-described apparatus cleaning process should be performed at the time of installation to the installation location after the conveyance from the manufacturing location to the installation location.

The substrate 9 may be a substrate (for example, a glass substrate, a printed circuit board, or the like) other than the semiconductor substrate.

The configurations in the above-described preferred embodiment and variations may be combined as appropriate only if those do not conflict with one another.

While the invention has been shown and described in detail, the foregoing description is in all aspects illustrative and not restrictive. It is therefore understood that numerous modifications and variations can be devised without departing from the scope of the invention.

### REFERENCE SIGNS LIST

- 4: Processing liquid supply line
- 9: Substrate
- 10: Substrate processing apparatus
- 21: Chamber
- 22: Spin chuck
- 26: Processing liquid nozzle
- 41: Storage tank (target space)
- 46, 47: Circulation line
- 81: Pure water supply source
- 82: Chemical liquid supply source
- 411: Drain port
- 412: Top surface
- 416: Breathing hole
- 422: Heater
- 460, 470: Circulation flow path
- S11 to S23: Step

## Claims

1. A cleaning method of a substrate processing apparatus (10), wherein
said substrate processing apparatus comprises:
a holder (22) for holding a substrate (9);
a processing liquid nozzle (26) for ejecting a processing liquid toward said substrate;
a processing liquid supply line (4) for supplying said processing liquid to said processing liquid nozzle; and
a chamber (21) inside which said holder and said processing liquid nozzle are disposed,
and wherein said processing liquid supply line includes a storage tank (41) capable of storing a liquid therein,
said cleaning method, comprising:
a) connecting a supply source (81, 82) of a predetermined cleaning solution to said processing liquid supply line (S11); and
b) causing a high-temperature cleaning solution obtained by heating said cleaning solution up to a temperature higher than a room temperature to flow into said processing liquid supply line to supply said high-temperature cleaning solution to a target space which is an inside of said storage tank or said chamber, to thereby generate a vapor of said cleaning solution inside said target space and condense said cleaning solution on a top surface (412) and/or a side surface of said target space (S21).

2. The cleaning method of a substrate processing apparatus according to claim 1, wherein
said target space is said storage tank, and
said high-temperature cleaning solution is filled into said storage tank up to a position lower than a breathing hole (416) provided in said storage tank in said operation b).

3. The cleaning method of a substrate processing apparatus according to claim 2, wherein
said processing liquid supply line further includes:
a circulation line (46, 47) for forming a circulation flow path (460, 470) in which said liquid circulates, together with said storage tank, by taking out said liquid inside said storage tank from one end thereof and returning said liquid into said storage tank from the other end thereof; and
a heater (422) for heating said liquid flowing in said circulation flow path, and
said cleaning solution circulating in said circulation flow path is heated by said heater in said operation b).

4. The cleaning method of a substrate processing apparatus according to claim 3, further comprising:
cleaning said circulation flow path by circulating said cleaning solution having a temperature lower than that of said high-temperature cleaning solution inside said circulation flow path and discharging said cleaning solution outside said circulation flow path before said operation b) (S18, S19).

5. The cleaning method of a substrate processing apparatus according to any one of claims 2 to 4, wherein
said storage tank has a drain port (411),
said cleaning method, further comprising:
cleaning said storage tank by filling said cleaning solution having a temperature lower than that of said high-temperature cleaning solution into said storage tank and discharging said cleaning solution outside from said drain port before said operation b) (S16, S17).

6. The cleaning method of a substrate processing apparatus according to any one of claims 2 to 5, wherein
another cleaning solution is supplied into said storage tank before said operation b), and
said another cleaning solution is an acid or alkaline liquid.

7. The cleaning method of a substrate processing apparatus according to claim 6, wherein
said cleaning solution is water and said another cleaning solution is an aqueous solution.

8. The cleaning method of a substrate processing apparatus according to any one of claims 1 to 7, wherein
a temperature of said high-temperature cleaning solution is not lower than 65 °C.

9. The cleaning method of a substrate processing apparatus according to any one of claims 1 to 8, which is performed at the time of installation to an installation location after conveyance of said substrate processing apparatus from a manufacturing location to said installation location.
